(19) Europäisches Patentamt
European Patent Office
Office européen des brevets

(11) EP 1 679 551 A1

(12) EUROPEAN PATENT APPLICATION

(43) Date of publication:
12.07.2006 Bulletin 2006/28

(51) Int Cl.:
G03F 7/20 (2006.01) G02B 17/06 (2006.01)

(21) Application number: 06004927.7

(22) Date of filing: 05.11.2001

(84) Designated Contracting States:
AT BE CH CY DE DK ES FI FR GB GR IE IT LI LU MC NL PT SE TR

(30) Priority: 07.11.2000 EP 00309871

(62) Document number(s) of the earlier application(s) in accordance with Art. 76 EPC:
01309353.9 / 1 209 503

(71) Applicant: ASML Netherlands B.V.
5504 DR Veldhoven (NL)

(72) Inventors:
- Bal, Matthieu Frederic
2628 TB Delft (NL)
- Bociort, Florian
2624 CV Delft (NL)
- Braat, Josephus Johannes Maria
2627 CA Delft (NL)

(74) Representative: Leeming, John Gerard
J.A. Kemp & Co.,
14 South Square,
Gray's Inn
London WC1R 5JJ (GB)

Remarks:
This application was filed on 10 - 03 - 2006 as a divisional application to the application mentioned under INID code 62.

# (54) Lithographic apparatus and device manufacturing method

(57) A classification system for systems of n mirrors, whereby systems of mirrors are classified by a number *C*, is defined as follows:

$$C = \sum_{i=1}^{n} a_i . 2^{(n-i)} \left( \frac{M}{|M|} \right)$$

where:

$a_i$ = 1 if the angle of incidence of the chief ray at mirror *i* is negative,
$a_i$ = 0 if the angle of incidence of the chief ray at mirror *i* is positive,
M is the magnification of the projection system, and index i numbers the mirrors of the system in series.

Four mirror systems in classes 2(-), 6(-), or 9(-), six mirror systems in classes 5(+), 6(-), 9(+), 13(+), 18(-), 21 (+), 22(-), 25(+), 29(+), 34(-), 37(+), 38(-), 42(-), and 54 (-) where (+) and (-) respectively indicate that the overall magnification of the system is positive or negative, and eight mirror systems in class 2(+), 5(+), 9(+), 12(+), 13 (+), 18(+), 18(-), 19(+), 20(+), 21(+), 22(+), 23(+), 25(+), 26(+), 34(-), 36(+), 37(+), 38(-), 45(+), 46(+), 49(+), 52 (+), 53(+), 54(+), 54(-), 55(-), 58(-), 68(+), 69(+), 73(+), 74(+) 77(+), 82(+), 82(-), 85(+), 88(+), 89(+), 90(-), 92(+), 93(+), 97(+), 100(-), 101 (+), 102(-), 104(+), 105(+), 106 (+), 106(-), 107(+), 108(+), 109(+), 109(-), 110(+), 110 (-), 111(+), 113(+), 11G(+), 117(+), 118(+), 118(-), 120 (+), 121(+), 122(-), 123(-), 132(+), 133(+), 134(-), 137(+), 138(+), 141(+), 145(+), 145(-), 146(+),146(-), 147(+), 148 (+), 148(-), 149(+), 150(+), 150(-), 151(+), 151(-), 152(-), 153(+), 154(+), 154(-), 155(+), 155(-), 156(+), 157(+), 159(+), 161(+), 162(-), 163(-), 164(+), 165(+), 166(+), 166(-), 167(+), 168(+), 169(+), 170(+), 170(-), 171(+), 172(+), 173(+), 174(+), 175(+), 176(+), 177(+), 178(-), 179(+), 180(+), 180(-), 181(+), 181(-), 182(+), 182(-), 183 (+), 183(-), 184(+), 185(+), 185(-), 186(-), 187(+), 187(-), 188(-), 189(+), 196(+), 197(+), 201 (+), 203(+), 205(+), 209(+), 214(-), 216(+), 217(+), 218(+), 218(-), 225(+), 228(+), 229(+), 230(+), 232(+), 233(+), 235(+), 236(+), 237(+), 238(-), 243(+), 246(+), 247(+), 248(+), 250(-), are useful in EUV lithography projection systems.

EP 1 679 551 A1

Printed by Jouve, 75001 PARIS (FR)

## Description

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. The required matrix addressing can be performed using suitable electronic means. More information on such mirror arrays can be gleaned, for example, from United States Patents US 5,296,891 and US 5,523,193, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
  For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus —commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally $< 1$), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual

layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, incorporated herein by reference.

No material suitable for manufacturing refractive lenses usable with EUV radiation is known. Accordingly, a projection system for a lithographic apparatus making use of EUV radiation for the projection beam must be based on reflective optics, generally with multi-layer coated mirrors. Projection systems for EUV radiation have been proposed, for example in:

"Design approach and comparison of projection cameras for EUV lithography", Lerner *et al* Opt. Eng. **39**(3) 792-802) March 2000; WO99/57596 (Braat); WO99/57606 (Braat), US 5,686,728 (Shafer) and US 5,815,310 (Williamson). These systems have various shortcomings, such as being far from telecentric or having very little working space, and a need exists for alternative systems. In a classification system described below, the Braat six-mirror systems fall into class 41 (+) and the Williamson six-mirror design falls into class 45(-). The four-mirror systems described by Lerner *et al* fall into classes 9(+) and 10(-). The six- and eight-mirror systems described by Shafer fall into classes 41 (+) and 165(+).

It is an object of the present invention to provide alternative and improved projection systems for EUV radiation and a methodology for designing such systems.

According to a first aspect of the present invention there is provided a lithographic projection apparatus comprising:

a radiation system for providing a projection beam of radiation;
a support structure for supporting patterning means, the patterning means serving to pattern the projection beam according to a desired pattern;
a substrate table for holding a substrate;
a projection system for projecting the patterned beam onto a target portion of the substrate,

characterized in that:

said projection system has precisely four imaging mirrors in the optical path of the projection beam and has an incidence angle classification, C, of 2(-), 6(-), or 9(-), where:

$$C = \sum_{i=1}^{4} a_i .2^{(4-i)} \quad \left(\frac{M}{|M|}\right)$$

$a_i$ = 1 if the angle of incidence of the chief ray at mirror *i* is negative,
$a_i$ = 0 if the angle of incidence of the chief ray at mirror *i* is positive,
M is the magnification of the projection system, and
the index *i* numbers the mirrors from object to image.

According to a second aspect of the present invention there is provided a lithographic projection apparatus comprising:

a radiation system for providing a projection beam of radiation;
a support structure for supporting patterning means, the patterning means serving to pattern the projection beam according to a desired pattern;
a substrate table for holding a substrate;
a projection system for projecting the patterned beam onto a target portion of the substrate,

characterized in that:

said projection system has precisely six imaging mirrors in the optical path of the projection beam and has an incidence angle classification, C, of 5(+), 6(-), 9(+), 13(+), 18(-), 21(+), 22(-), 25(+), 29(+), 34(-), 37(+), 38(-), 42(-), or 54(-), where:

$$C = \sum_{i=1}^{6} a_i . 2^{(6-i)} \quad \left(\frac{M}{|M|}\right)$$

$a_i$ = 1 if the angle of incidence of the chief ray at mirror *i* is negative,
$a_i$ = 0 if the angle of incidence of the chief ray at mirror *i* is positive,
M is the magnification of the projection system, and
the index *i* numbers the mirrors from object to image.

According to a third aspect of the present invention there is provided a lithographic projection apparatus comprising:

a radiation system for providing a projection beam of radiation;
a support structure for supporting patterning means, the patterning means serving to pattern the projection beam according to a desired pattern;
a substrate table for holding a substrate;
a projection system for projecting the patterned beam onto a target portion of the substrate,
characterized in that:

said projection system has precisely eight imaging mirrors in the optical path of the projection beam and has an incidence angle classification, C, of 2(+), 5(+), 9(+), 12(+), 13(+), 18(+), 18(-), 19(+), 20(+), 21(+), 22(+), 23 (+), 25(+), 26(+), 34(-), 36(+), 37(+), 38(-), 45(+), 46(+), 49(+), 52(+), 53(+), 54(+), 54(-), 55(-), 58(-), 68(+), 69 (+), 73(+), 74(+) 77(+), 82(+), 82(-), 85(+), 88(+), 89(+), 90(-), 92(+), 93(+), 97(+), 100(-), 101(+), 102(-), 104 (+), 105(+), 106(+), 106(-), 107(+), 108(+), 109(+), 109(-), 110(+), 110(-), 111(+), 113(+), 116(+), 117(+), 118 (+), 118(-), 120(+), 121(+), 122(-), 123(-), 132(+), 133(+), 134(-), 137(+), 138(+), 141 (+), 145(+), 145(-), 146 (+), 146(-), 147(+), 148(+), 148(-), 149(+), 150(+), 150(-), 151(+), 151(-), 152(-), 153(+), 154(+), 154(-), 155(+), 155(-), 156(+), 157(+), 159(+), 161(+), 162(-), 163(-), 164(+), 165(+), 166(+), 166(-), 167(+), 168(+), 169(+), 170(+), 170(-), 171(+), 172(+), 173(+), 174(+), 175(+), 176(+), 177(+), 178(-), 179(+), 180(+), 180(-), 181(+), 181(-), 182(+), 182(-), 183(+), 183(-), 184(+), 185(+), 185(-), 186(-), 187(+), 187(-), 188(-), 189(+), 196(+), 197 (+), 201(+), 203(+), 205(+), 209(+), 214(-), 216(+), 217(+), 218(+), 218(-), 225(+), 228(+), 229(+), 230(+), 232 (+), 233(+), 235(+), 236(+), 237(+), 238(-), 243(+), 246(+), 247(+), 248(+), 250(-), where:

$$C = \sum_{i=1}^{8} a_i . 2^{(8-i)} \quad \left(\frac{M}{|M|}\right)$$

$a_i$ = 1 if the angle of incidence of the chief ray at mirror *i* is negative,
$a_i$ = 0 if the angle of incidence of the chief ray at mirror *i* is positive,
M is the magnification of the projection system, and
the index *i* numbers the mirrors from object to image.

An embodiment of the present invention may comprise a four-mirror projection system in class 6(-) with a numerical aperture of 0.15, a ring field between -22.8mm and -23.8mm on the image side, and a transverse magnification

of -0.2 at a wavelength of 13nm. Such a system can have a minimum Strehl ratio of 0.972, a maximal wavefront error of 0.0266 waves and a maximal distortion of 12nm.

The present invention, in a fourth aspect also provides a device manufacturing method using a lithography apparatus comprising:

an illumination system constructed and arranged to supply a projection beam of radiation;
a first object table constructed to hold a mask;
a second object table constructed to hold a substrate; and
a projection system constructed and arranged to image an irradiated portion of the mask onto target areas of the substrate; the method comprising the steps of:

providing a mask containing a pattern to said first object table;
providing a substrate which is at least partially covered by a layer of radiation-sensitive material to said second object table;
irradiating portions of the mask and imaging said irradiated portions of said mask onto said target areas of said substrate; characterized in that:

in the step of imaging, a projection system as defined in any one of the first, second and third aspects described above is used.

In a manufacturing process using a lithographic projection apparatus according to the invention a pattern in a mask is imaged onto a substrate which is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

The present invention and its attendant advantages will be described below with reference to exemplary embodiments and the accompanying schematic drawings, in which:

Fig. 1 depicts a lithographic projection apparatus according to a first embodiment of the invention;
Fig. 2 is a diagram used in explaining the incidence angle classification system of the present invention;
Fig. 3 is a diagram showing the thickness and curvature definitions used in the present invention;
Fig. 4 is a diagram used in explaining how beam obstruction in a mirror design is determined;
Fig. 5 is a diagram used in explaining how certain constraints are applied in designing mirror systems according to the invention;
Figs. 6 to 19 are diagrams of mirror systems according to various embodiments of the invention.

In the various drawings, like parts are indicated by like references.

Embodiment 1

Figure 1 schematically depicts a lithographic projection apparatus according to a particular embodiment of the invention. The apparatus comprises:

- a radiation system Ex, IL, for supplying a projection beam PB of radiation (e.g. EUV radiation), which in this particular case also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL;
- a projection system ("lens") PL (e.g. a mirror group) for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a discharge or laser-produced plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1 /5). In this manner, a relatively large target portion C can be exposed, without having to compromise on resolution.

Mirror System Classification

According to the present invention, a mirror system of *n* mirrors is classified by reference to the direction of the reflected beam compared to the incident beam at each mirror surface. Having defined the object height to be positive along a Y-axis and a suitable reference plane, e.g. the plane containing the optical axis Z of the projection system and the Y-axis (as shown in Figure 1), the chief ray CR at a mirror is defined as having a positive angle of incidence $\alpha$, if the angle between the normal of the surface and the incident ray is counterclockwise (as shown in Figure 2) and a negative

angle of incidence if the angle between the normal and the incident ray is clockwise. Further, one should view this reference plane along a positive X direction, the X, Y, Z directions making up a right-handed orthogonal coordinate system, as shown in Figure 1. The chief ray is defined as that ray emerging from the object point, which goes through the center of the stop and therefore also through the center of the entrance and exit pupils, i.e. at a height equal to zero from the optical axis. (NB this assignment is arbitrary, the scheme can be implemented with either relative direction of reflection regarded as positive, provided that the assignment is consistent.) By assigning the binary digit "1" to a negative angle of incidence and "0" to a positive angle of incidence of the chief ray, a mirror system is assigned a binary number defined by the sequence of binary digits assigned to each mirror in the system in sequence along the optical path of the beam from object to source. For convenience, this binary number is expressed in decimal notation.

The various classes of the incidence angle classification system are further characterized by indicating the sign of the magnification of the system. Herein, this is indicated by the appropriate sign in parentheses after the class number, e.g. 6(-). The sign is obtained by dividing the magnification M by its absolute value |M|. A system has a positive magnification if the object and image are the same side of the optical axis and a negative magnification if they are opposite sides.

The decimal incidence angle classification, C, can thus be expressed as:

$$C = \sum_{i=1}^{n} a_i . 2^{(n-i)} \left( \frac{M}{|M|} \right) \quad \textbf{(1)}$$

where: $a_i$ = 1 if the angle of incidence of the chief ray at mirror $i$ is negative,
$a_i$ = 0 if the angle of incidence of the chief ray at mirror $i$ is positive,
M is the magnification of the projection system, and
index $i$ numbers the mirrors of the system in series from object to source.

Figure 2 shows the four possible arrangements of incident chief rays CR and mirrors M. In A the incident chief ray is travelling left to right and has an angle of incidence $\alpha > 0$, so $a_i = 0$. In B the incident chief ray is travelling right to left and has an angle of incidence $\alpha < 0$, so $a_i = 1$. In C the incident chief ray is travelling right to left and has an angle of incidence $\alpha > 0$, so $a_i = 0$. In D the incident chief ray is travelling left to right with an angle of incidence $\alpha < 0$, so $a_i$ = 1. Note that although convex mirrors are shown, the same assignments apply with concave or plane mirrors.

Whilst the incidence angle classification C does not wholly define a mirror system, the basic layout of a system is inherent in its incidence angle classification. By reference to whether the reflection at a given mirror is positive or negative, the orientation of that mirror and the position of the succeeding mirror, above or below the beam, can be determined. Thus a given classification number can be used by the designer of a mirror system to set out the system prior to optimization of that system, e.g. using commercially available ray tracing software such as CODE V(TM) by Optical Research Associates, Pasadena, California, USA. It should be noted that previous classifications of mirror systems based on whether the curvature, and hence power, of each mirror in the system is positive or negative, do not give any information as to the layout of a mirror system. It will also be noted that the incidence angle classification of a given mirror system can readily be determined from simple inspection of the beam path.

Using the above classification system and numerical simulations, the present inventors have determined that only certain classes contain mirror systems usable as the projection system in a lithographic projection system. For four-mirror systems, feasible projection systems exist in classes 2(-), 6(-), 9(+), 9(-) and 10(-). For six-mirror systems, feasible projection systems exist in classes 5(+), 6(-), 9(+), 13(+), 18(-), 21(+), 22(-), 25(+), 26(-), 29(+), 34(-), 37(+), 38(-), 41 (+), 42(-), 45(+) and 54(-). For eight-mirror systems, feasible projection systems exist in class 2(+), 5(+), 9(+), 12(+), 13 (+), 18(+), 18(-), 19(+), 20(+), 21(+), 22(+), 23(+), 25(+), 26(+), 34(-), 36(+), 37(+), 38(-), 45(+), 46(+), 49(+), 52(+), 53 (+), 54(+), 54(-), 55(-), 58(-), 68(+), 69(+), 73(+), 74(+) 77(+), 82(+), 82(-), 85(+), 88(+), 89(+), 90(-), 92(+), 93(+), 97(+), 100(-), 101(+), 102(-), 104(+), 105(+), 106(+), 106(-), 107(+), 108(+), 109(+), 109(-), 110(+), 110(-), 111(+), 113(+), 116 (+), 117(+), 118(+), 118(-), 120(+), 121(+), 122(-), 123(-), 132(+), 133(+), 134(-), 137(+), 138(+), 141(+), 145(+), 145(-), 146(+), 146(-), 147(+), 148(+), 148(-), 149(+), 150(+), 150(-), 151(+), 151(-), 152(-), 153(+), 154(+), 154(-), 155(+), 155 (-), 156(+), 157(+), 159(+), 161(+), 162(-), 163(-), 164(+), 165(+), 166(+), 166(-), 167(+), 168(+), 169(+), 170(+), 170(-), 171(+), 172(+), 173(+), 174(+), 175(+), 176(+), 177(+), 178(-), 179(+), 180(+), 180(-), 181(+), 181(-), 182(+), -182(-), 183(+), 183(-), 184(+), 185(+), 185(-), 186(-), 187(+), 187(-), 188(-), 189(+), 196(+), 197(+), 201(+), 203(+), 205(+), 209 (+), 214(-), 216(+), 217(+), 218(+), 218(-), 225(+), 228(+), 229(+), 230(+), 232(+), 233(+), 235(+), 236(+), 237(+), 238 (-), 243(+), 246(+), 247(+), 248(+), 250(-).

## Design Methodology

As mentioned above, a given class defines an outline layout for a mirror system for which a functional projection system can be designed. A methodology according to the present invention for such a design process is described below.

In the design process according to the invention, the mirrors in a system are defined by "thicknesses" and curvatures, defined as shown in Figure 3. (NB the term "thickness" is used by analogy to refractive systems which are conventionally defined in terms of surface curvatures, thicknesses between surfaces and the refractive indices of the media between surfaces.) Thus, thickness $d_0$ is the distance between the object, the mask MA in the present case of a projection system in a lithographic apparatus, and the intersection of the (imaging extended) first mirror $M_1$ with the optical axis OA. The distance between the intersections of the (imaging extended) first mirror $M_1$ and the (imaging extended) second mirror $M_2$ with the optical axis OA is $d_1$. Note that since the second mirror is situated between the first mirror $M_1$ and the object (mask MA), thickness $d_1$, is negative. In general, thickness $d_i$ is the distance between the intersections of mirror $M_i$ and mirror $M_{i+1}$ with the optical axis OA. For an n-mirror system, the thickness $d_n$ is the distance between the last mirror $M_n$ and the image plane, where the substrate W is positioned in a lithographic projection apparatus. In specific embodiments described below, an additional thickness $d_{n+1}$, is given, this represents the distance between the position of the image calculated using a first order approximation and using a real ray tracing algorithm.

In a first step the design method identifies conceivable systems under a number of constraints by using a paraxial approach described below. Those systems should not present obscuration, as is also described further below. The paraxial approach and the constraints yield a limited number of variables that are sampled to identify solutions. In a further step those solutions are checked using a real ray tracing method, referred to above, in which the paraxial assumptions are not present and in which also multilayer coatings of the reflectors may be modelled.

Paraxial Approach

The present inventors have developed an approach to designing mirror systems which starts with a paraxial approximation of a mirror system using matrix formalism. In a paraxial approximation the sine of an angle is approximated as the angle, i.e. $\sin\alpha = \alpha$, and are the mirrors considered as being flat, while the actual curvature of a mirror is considered only to affect the angle of an incident ray, not its point of intersection with the supposedly 'flat' surface.

In a matrix formalism, such as described in "Introduction to Optics" by Frank & Leno Pedrotti, Prentice Hall 1993; ISBN: 0135015456, incorporated herein by reference, the description of an optical system consist of an accumulation of translation and reflection (and/or refraction in a catadioptric or refractive system) matrices $M_{trans}$, $M_{refl}$ which are defined as follows:

$$M_{trans} = \begin{bmatrix} 1 & d_i \\ 0 & 1 \end{bmatrix} \quad (2)$$

$$M_{refl} = \begin{bmatrix} 1 & 0 \\ -2.c_i & -1 \end{bmatrix} \quad (3)$$

where $d_i$ is the distance to the next surface and $c_i$ the curvature of the surface, which is positive if the center of the sphere is on the right side of the surface. The path of a ray is given by a vector made of a height (distance from the optical axis) and an angle: [height, angle]. The multiplication of the vector with one or more matrices gives the ray after the corresponding translations or reflections.

The system matrix is the multiplication of all the matrices in the system. The first matrix is the reflection matrix of the first surface, the penultimate matrix is the translation matrix of the thickness preceding the last reflective surface and the last matrix is the reflection matrix of the last reflective surface. The effective focal length, the back focal length, the front focal length and the paraxial image distance can be derived from the system matrix as follows.

If the system matrix is defined as:

$$M_{system} = \begin{bmatrix} a & b \\ c & d \end{bmatrix} \quad (4)$$

then the effective focal length is given by:

$$efl = -\frac{1}{c} \qquad (5)$$

the back focal length is given by:

$$bfl = -\frac{a}{c} \qquad (6)$$

the front focal length is given by:

$$ffl = \frac{d}{c} \qquad (7)$$

and the paraxial image distance, i.e. the distance between the last reflective surface and the image plane, is given by:

$$d_n = \frac{a.d_0 + b}{c.d_0 + d} \qquad (8)$$

where $d_0 = \frac{ad - cb - magn\ .\ d}{magn\ .\ c}$ and *magn* is the magnification of the system.

The system matrix for the first part of the system, from the object plane to the stop (pupil) can be represented as:

$$M_{1st} = \begin{bmatrix} a_{1st} & b_{1st} \\ c_{1st} & d_{1st} \end{bmatrix} \qquad (9)$$

so that the distance, $L_{enpup}$, to the entrance pupil is given by:

$$\begin{bmatrix} a_{1st} & b_{1st} \\ c_{1st} & d_{1st} \end{bmatrix} . \begin{bmatrix} 1 & L_{enpup} \\ 0 & 1 \end{bmatrix} . \begin{bmatrix} 0 \\ A_{enpup} \end{bmatrix} = \begin{bmatrix} (a_{1st}.L_{enpup} + b_{1st}).A_{enpup} \\ (c_{1st}.L_{enpup} + d_{1st}).A_{enpup} \end{bmatrix} = \begin{bmatrix} 0 \\ A_{stop} \end{bmatrix} \qquad (10)$$

The second part of the system, from stop to image surface can be represented as:

$$M_{2nd} = \begin{bmatrix} a_{2nd} & b_{2nd} \\ c_{2nd} & d_{2nd} \end{bmatrix} \qquad (11)$$

so that the distance, $L_{expup}$, to the exit pupil is given by:

$$\begin{bmatrix} 1 & L_{\exp up} \\ 0 & 1 \end{bmatrix} . \begin{bmatrix} a_{2nd} & b_{2nd} \\ c_{2nd} & d_{2nd} \end{bmatrix} . \begin{bmatrix} 0 \\ A_{stop} \end{bmatrix} = \begin{bmatrix} (b_{2nd} + L_{\exp up}.d_{2nd}).A_{stop} \\ D_{2nd}.A_{stop} \end{bmatrix} = \begin{bmatrix} 0 \\ A_{\exp up} \end{bmatrix} \qquad (12)$$

The distances to the entrance and exit pupils, if $A_{enpup} \neq 0$, are then given by:

$$L_{enpup} = -\frac{b_{1st}}{a_{1st}} \text{ and } L_{\exp up} = -\frac{b_{2nd}}{d_{2nd}} \quad (13)$$

Constraints

Given the above, various constraints that must be applied to the system can be used to determine equations for the curvatures and thicknesses of certain surfaces of the system as functions of the constraints and other curvatures and thicknesses. Some example constraints G1 to G4 are shown in Figure 5.

A first constraint G1 is minimum deviation from telecentricity on the object side that still enables obscuration-free illumination of the object, which may determine the curvature of the first surface or the thickness between mirrors 1 and 2. Another constraint G3, is perfect telecentricity on the image side, which may determine the curvature of the last surface or the thickness between the final and penultimate mirrors. This telecentricity requirement is equivalent to the requirement that the exit pupil is at infinity. The requirement that the object and the image are conjugated and have a prescribed value of the transverse magnification fixes the values of the object (G2) and image (G4) distances.

The object distance G2, the first thickness, can be solved as a function of the desired magnification of the system: the paraxial image distance is inserted in the thickness of the surface immediately preceding the image plane and the object distance is modified to satisfy:

$$M = \frac{\text{Image Height}}{\text{Object Height}} \quad (14)$$

In current lithography apparatus, M is usually set as ±0.20 or ±0.25, i.e. reduction by a factor of 5 or 4 respectively.

A minimum deviation from telecentricity at the object side is an important requirement in lithography. The reflective object (mask MA) is illuminated with a beam coming from the radiation system. The chief ray angle at the object must be such that the incident illuminating beam does not interfere with the beam reflected from the object and going into the projection system. The angle of the chief ray together with the numerical aperture on the object side should be almost zero and the angles of all rays must be smaller or larger than zero, to fulfil these two requirements. For telecentricity on the image side, the angle of the chief ray relative to the optical axis has to be zero. The size of the last mirror increases quickly as a function of the distance between the image and the last mirror, due to the relatively large numerical aperture.

A system with zero or an even number of intermediate images has a negative magnification. To have an overall system with a positive magnification the number of intermediate images has to be odd.

The working distance at the object side is the minimum distance between the object plane and the surface closest to the object, most of the time the second mirror. On the image side the working distance is the minimum distance between the image plane and the plane closest to the image, most often the penultimate mirror. The working distances provide room for mirror supports and for mechanical movements of the object and the image and must not be too small.

An example of applying the above constraints in a six-mirror system is described below. This may be carried out in practice using software such as Maple(TM) produced by Waterloo Maple Inc. 57 Erb Street W. Waterloo, Ontario Canada N2L 6C2.

First is a derivation of the formulas used for a six-mirror system, but the formulas are also valid for other numbers of mirrors, using the paraxial approach. In the matrix notation a ray is defined by the vector: [height, angle in radians]. After a distance $d_i$ the ray [y,a] will be:

$$\begin{bmatrix} y + d_i a \\ a \end{bmatrix} \quad (15)$$

using the matrix given in equation (2).
After a mirror with curvature $c_i$ the ray [y,a] will have the same height but a different angle:

$$\begin{bmatrix} y \\ -2\, c_i\, y - a \end{bmatrix} \tag{16}$$

using the matrix given in equation (3).

To derive formulas used later on, firstly the distance between mirror 5 and 6 is solved by requiring telecentricity in the image of the ray going through the optical axis in the stop surface. The following matrix A is from the stop surface to after the 5th mirror, as we don't now where we will locate the stop surface we take an unknown 2 by 2 matrix:

$$A := \begin{bmatrix} a & b \\ c & d \end{bmatrix} \tag{17}$$

From the 5th mirror we travel a distance la to the 6th mirror, la is the variable to solve now.

$$L6 := \begin{bmatrix} 1 & la \\ 0 & 1 \end{bmatrix} \tag{18}$$

Matrix MC is of the 6th mirror surface:

$$MC := \begin{bmatrix} 1 & 0 \\ -2\, c6 & -1 \end{bmatrix} \tag{19}$$

The ray going through the center of the stop with an arbitrary angle *ap* is:

$$Y := \begin{bmatrix} 0 \\ ap \end{bmatrix} \tag{20}$$

That ray after the 6th mirror will be:

$$Y_image := \begin{bmatrix} (b + la\, d)\, ap \\ (-2\, c6\, b + (-2\, c6\, la - 1)\, d)\, ap \end{bmatrix} \tag{21}$$

in which the angle is equal to zero since telecentricity is required and the solution *opl* for the distance *la* between mirror five and six is now

$$opl := -\frac{1}{2}\frac{2\, c6\, b + d}{c6\, d} \tag{22}$$

The matrix from the stop surface to after the 6th mirror is now:

$$B := \begin{bmatrix} \frac{1}{2}\frac{2\,c6\,a\,d - 2\,c6\,b\,c - c\,d}{c6\,d} & -\frac{1}{2}\frac{d}{c6} \\ -2\frac{c6\,(d\,a - b\,c)}{d} & 0 \end{bmatrix} \quad (23)$$

The next solve is the distance *d* between the object and the first mirror and the solve *ya* for the angle of the chief ray (going through the center of the stop) between the object and the first mirror.

The ray *Ya* in the object point *yob* with the desired angle *ya* is given by the vector:

$$Ya := \begin{bmatrix} yob \\ ya \end{bmatrix} \quad (24)$$

and the distance *l* between the object and the first mirror surface by the matrix:

$$L := \begin{bmatrix} 1 & l \\ 0 & 1 \end{bmatrix} \quad (25)$$

The first mirror surface is given by:

$$MC := \begin{bmatrix} 1 & 0 \\ -2\,c1 & -1 \end{bmatrix} \quad (26)$$

The distance m between the first mirror and the second mirror is given by:

$$M := \begin{bmatrix} 1 & m \\ 0 & 1 \end{bmatrix} \quad (27)$$

The unknown matrix from the second mirror surface to the stop position is defined as

$$A := \begin{bmatrix} e & f \\ g & h \end{bmatrix} \quad (28)$$

The chief ray in the stop surface is now:

$$Y_stop := \begin{bmatrix} (e - 2\,(e\,m + f)\,c1)\,yob + ((e - 2\,(e\,m + f)\,c1)\,l - e\,m - f)\,ya \\ (g - 2\,(g\,m + h)\,c1)\,yob + ((g - 2\,(g\,m + h)\,c1)\,l - g\,m - h)\,ya \end{bmatrix} \quad (29)$$

and in the image the chief ray is:

$$Y_image := \left[\left(\frac{1}{2}\frac{(2\,c6\,a\,d - 2\,c6\,b\,c - c\,d)\,e}{c6\,d} - \frac{1}{2}\frac{d\,g}{c6} - 2\left(\left(\frac{1}{2}\frac{(2\,c6\,a\,d - 2\,c6\,b\,c - c\,d)\,e}{c6\,d} - \frac{1}{2}\frac{d\,g}{c6}\right)m + \frac{1}{2}\frac{(2\,c6\,a\,d - 2\,c6\,b\,c - c\,d)\,f}{c6\,d} - \frac{1}{2}\frac{d\,h}{c6}\right)c1\right)yob\right.$$

$$+\left(\left(\frac{1}{2}\frac{(2\,c6\,a\,d - 2\,c6\,b\,c - c\,d)\,e}{c6\,d} - \frac{1}{2}\frac{d\,g}{c6} - 2\left(\left(\frac{1}{2}\frac{(2\,c6\,a\,d - 2\,c6\,b\,c - c\,d)\,e}{c6\,d} - \frac{1}{2}\frac{d\,g}{c6}\right)m + \frac{1}{2}\frac{(2\,c6\,a\,d - 2\,c6\,b\,c - c\,d)\,f}{c6\,d} - \frac{1}{2}\frac{d\,h}{c6}\right)c1\right)l\right.$$

$$\left.\left.-\left(\frac{1}{2}\frac{(2\,c6\,a\,d - 2\,c6\,b\,c - c\,d)\,e}{c6\,d} - \frac{1}{2}\frac{d\,g}{c6}\right)m - \frac{1}{2}\frac{(2\,c6\,a\,d - 2\,c6\,b\,c - c\,d)\,f}{c6\,d} + \frac{1}{2}\frac{d\,h}{c6}\right)ya\right]$$

$$\left[\left(-2\frac{c6\,(d\,a - b\,c)\,e}{d} - 2\left(-2\frac{c6\,(d\,a - b\,c)\,e\,m}{d} - 2\frac{c6\,(d\,a - b\,c)\,f}{d}\right)c1\right)yob\right.$$

$$\left.+\left(\left(-2\frac{c6\,(d\,a - b\,c)\,e}{d} - 2\left(-2\frac{c6\,(d\,a - b\,c)\,e\,m}{d} - 2\frac{c6\,(d\,a - b\,c)\,f}{d}\right)c1\right)l + 2\frac{c6\,(d\,a - b\,c)\,e\,m}{d} + 2\frac{c6\,(d\,a - b\,c)\,f}{d}\right)ya\right] \tag{30}$$

The height of the chief ray in the image is by definition magn * height in the object surface (*yob*), we solve *l* from equation (30) to impose this reduction to the system giving:

$$Y_image_l := -\,(2\,yob\;e\;c6\;a\;d - 2\,yob\;e\;c6\;b\;c - yob\;e\;c\;d - yob\;d^2\,g - 4\,yob\;c1\;m\;e\;c6\;a\;d$$
$$+ 4\,yob\;c1\;m\;e\;c6\;b\;c + 2\,yob\;c1\;m\;e\;c\;d + 2\,yob\;c1\;m\;d^2\,g - 4\,yob\;c1\;f\;c6\;a\;d + 4\,yob\;c1\;f\;c6\;b\;c$$
$$+ 2\,yob\;c1\;f\;c\;d + 2\,yob\;c1\;d^2\,h - 2\,ya\;m\;e\;c6\;a\;d + 2\,ya\;m\;e\;c6\;b\;c + ya\;m\;e\;c\;d + ya\;m\;d^2\,g$$
$$- 2\,ya\;f\;c6\;a\;d + 2\,ya\;f\;c6\;b\;c + ya\;f\;c\;d + ya\;d^2\,h - 2\;magn\;yob\;c6\;d)$$
$$\Big/\;(\,(2\,e\;c6\;a\;d - 2\,e\;c6\;b\;c - e\;c\;d - d^2\,g - 4\,c1\;m\;e\;c6\;a\;d + 4\,c1\;m\;e\;c6\;b\;c + 2\,c1\;m\;e\;c\;d$$
$$+ 2\,c1\;m\;d^2\,g - 4\,c1\;f\;c6\;a\;d + 4\,c1\;f\;c6\;b\;c + 2\,c1\;f\;c\;d + 2\,c1\;d^2\,h)\,ya\,) \tag{31}$$

and we force the height of the chief ray to be zero in the stop surface in equation (29), as it should be by definition to solve the distance m:

$$Y_stop_m := -\frac{-yob\,e + 2\,yob\,f\,c1 - ya\,l\,e + 2\,ya\,l\,f\,c1 + ya\,f}{e\,(2\,yob\,c1 + 2\,ya\,c1\,l + ya)} \tag{32}$$

The solution for the distance *m* between the first and the second mirror now becomes:

$$Y_stop_m := \frac{1}{4}\frac{-4\,f\,c1\,magn\,yob\,c6 + 2\,e\,magn\,yob\,c6 - e\,ya\,d\,h + ya\,f\,d\,g}{e\,c1\,magn\,yob\,c6} \tag{33}$$

The solution for the distance / between the object and the first mirror now is:

$$Y_image_l := -\frac{1}{2}\frac{ya\,f\,d\,g + 2\,d\,yob\,c1\,f\,g - e\,ya\,d\,h - 2\,d\,e\,yob\,c1\,h + 2\,e\,magn\,yob\,c6}{ya\,(f\,g - e\,h)\,c1\,d} \tag{34}$$

We substitute the just derived expressions in the matrices L and *M* of equations (25) and (27).

$$M := \begin{bmatrix} 1 & \frac{1}{4}\frac{-4\, f\, c1\, magn\, yob\, c6 + 2\, e\, magn\, yob\, c6 - e\, ya\, d\, h + ya\, f\, d\, g}{e\, c1\, magn\, yob\, c6} \\ 0 & 1 \end{bmatrix} \quad (35)$$

$$L := \begin{bmatrix} 1 & -\frac{1}{2}\frac{ya\, f\, d\, g + 2\, d\, yob\, c1\, f\, g - e\, ya\, d\, h - 2\, d\, e\, yob\, c1\, h + 2\, e\, magn\, yob\, c6}{ya\,(f\, g - e\, h)\, c1\, d} \\ 0 & 1 \end{bmatrix} \quad (36)$$

And as a check we calculate the chief ray after the 6th surface with the new expressions. We see that the angle is always zero and that the height is the object height multiplied with magnification.

$$Y_image := \begin{bmatrix} magn\, yob \\ 0 \end{bmatrix} \quad (37)$$

The final solve is the distance n between the last mirror surface and the image surface. In the image surface all rays from the same object point come together in a point with a height = magnification * object height.

First we define a ray *Yb* from the object point *yob* and an arbitrary angle *yb*.

$$Yb := \begin{bmatrix} yob \\ yb \end{bmatrix} \quad (38)$$

$$N := \begin{bmatrix} 1 & n \\ 0 & 1 \end{bmatrix} \quad (39)$$

In the image this ray *Yb* will become:

$$
\begin{aligned}
&Y_image := \\
&\Big[ -\frac{1}{4}\big(-f\,g^2\,d^2\,ya^2 + g\,d^2\,e\,ya^2\,h - g\,yb\,d^2\,e\,ya\,h + 2\,yb\,e^2\,c6\,a\,d\,ya\,h - 4\,yb\,magn^2\,yob\,c6^2\,e \\
&\quad - 4\,yb\,e^2\,n\,c6^2\,d\,a\,ya\,h + 4\,yb\,e^2\,n\,c6^2\,b\,c\,ya\,h + e^2\,c\,d\,ya^2\,h - 4\,e^2\,n\,c6^2\,b\,c\,ya^2\,h \\
&\quad + 4\,e^2\,n\,c6^2\,d\,a\,ya^2\,h + 2\,e^2\,c6\,b\,c\,ya^2\,h - 2\,e^2\,c6\,a\,d\,ya^2\,h - 2\,yb\,e^2\,c6\,b\,c\,ya\,h \\
&\quad - 4\,ya\,d\,c1\,magn\,yob\,c6\,e\,h + 4\,yb\,d\,c1\,magn\,yob\,c6\,e\,h - yb\,e^2\,c\,d\,ya\,h + f\,g^2\,yb\,d^2\,ya + f\,g\,yb\,e\,c\,d\,ya \\
&\quad - 4\,f\,g\,e\,n\,c6^2\,d\,a\,ya^2 + 2\,f\,g\,yb\,e\,c6\,b\,c\,ya - 2\,f\,g\,e\,c6\,b\,c\,ya^2 - 4\,f\,g\,yb\,d\,c1\,magn\,yob\,c6 \\
&\quad + 2\,f\,g\,e\,c6\,a\,d\,ya^2 + 4\,f\,g\,ya\,d\,c1\,magn\,yob\,c6 + 4\,f\,g\,e\,n\,c6^2\,b\,c\,ya^2 - f\,g\,e\,c\,d\,ya^2 \\
&\quad + 4\,f\,g\,yb\,e\,n\,c6^2\,d\,a\,ya - 4\,f\,g\,yb\,e\,n\,c6^2\,b\,c\,ya - 2\,f\,g\,yb\,e\,c6\,a\,d\,ya\big) \Big/ \left(ya\,magn\,e\,c6^2\right)\Big] \\
&\left[-\frac{(-ya + yb)\,(f\,g - e\,h)\,(d\,a - b\,c)}{magn}\right]
\end{aligned}
\qquad (40)
$$

The expression for the image distance n is, given that the image height is equal to *magn.yob*:

$$
\begin{aligned}
Y_image_n := -\frac{1}{4}\big(&-d^2\,g\,e\,ya\,h + 2\,e^2\,c6\,a\,d\,ya\,h - 4\,magn^2\,yob\,c6^2\,e + 2\,e\,c6\,b\,c\,ya\,f\,g \\
&- 4\,d\,g\,f\,c1\,magn\,yob\,c6 - 2\,e^2\,c6\,b\,c\,ya\,h + e\,c\,d\,ya\,f\,g + 4\,d\,h\,c6\,e\,c1\,magn\,yob - e^2\,c\,d\,ya\,h \\
&+ d^2\,g^2\,ya\,f - 2\,e\,c6\,a\,d\,ya\,f\,g\big) \Big/ \left((-e\,d\,a\,h + e\,b\,c\,h + f\,g\,d\,a - f\,g\,b\,c)\,e\,c6^2\,ya\right)
\end{aligned}
\qquad (41)
$$

<u>6-mirror system, stop on mirror 2</u>

Now we use these derivations in the first part: solving the variables of a six-mirror system with the stop position on mirror two, defining thicknesses as *d:=*[*d0,d1,d2,d3,d4,d5,d6*] and the curvatures as *c:=*[*c1,c2,c3,c4,c5,c6*]. The stop (pupil) position is on the second surface.

A limitation on the Petzval sum (i.e. the sum of curvatures in the system, curvatures of odd surfaces being subtracted from curvatures of even surfaces, or vice versa), e.g. to be zero, can be introduced and used to solve the curvature of the stop surface. However, a zero Petzval sum is not essential and an non-zero value can be accommodated.

Now we define all the matrices in the system, the reflectance (even subscripts) and translation (odd subscripts) matrices, from the object to the image.

$$M_1 := \begin{bmatrix} 1 & d0 \\ 0 & 1 \end{bmatrix} \qquad M_2 := \begin{bmatrix} 1 & 0 \\ -2\,c1 & -1 \end{bmatrix}$$

$$M_3 := \begin{bmatrix} 1 & d1 \\ 0 & 1 \end{bmatrix} \qquad M_4 := \begin{bmatrix} 1 & 0 \\ -2\,c2 & -1 \end{bmatrix}$$

$$M_5 := \begin{bmatrix} 1 & d2 \\ 0 & 1 \end{bmatrix} \qquad M_6 := \begin{bmatrix} 1 & 0 \\ -2\,c3 & -1 \end{bmatrix}$$

$$M_7 := \begin{bmatrix} 1 & d3 \\ 0 & 1 \end{bmatrix} \qquad M_8 := \begin{bmatrix} 1 & 0 \\ -2\,c4 & -1 \end{bmatrix}$$

$$M_9 := \begin{bmatrix} 1 & d4 \\ 0 & 1 \end{bmatrix} \qquad M_{10} := \begin{bmatrix} 1 & 0 \\ -2\,c5 & -1 \end{bmatrix}$$

$$M_{11} := \begin{bmatrix} 1 & d5 \\ 0 & 1 \end{bmatrix} \qquad M_{12} := \begin{bmatrix} 1 & 0 \\ -2\,c6 & -1 \end{bmatrix}$$

$$M_{13} := \begin{bmatrix} 1 & d6 \\ 0 & 1 \end{bmatrix}$$

**(42)**

The first solve is the exit pupil in infinity or telecentricity in the image. The angle of the ray going through the optical axis in the stop surface should be zero in the image. The matrix from the stop surface to the fifth mirror generated by multiplication of the appropriate M matrices derived just above, is given by:

$$\begin{bmatrix} 1 - 2\,d3\,c3 + d4\,(-2\,c4\,(1 - 2\,d3\,c3) + 2\,c3), & d2 + d3\,(-2\,c3\,d2 - 1) + d4\,(-2\,c4\,(d2 + d3\,(-2\,c3\,d2 - 1)) + 2\,c3\,d2 + 1) \\ -2\,c5\,(1 - 2\,d3\,c3 + d4\,(-2\,c4\,(1 - 2\,d3\,c3) + 2\,c3)) + 2\,c4\,(1 - 2\,d3\,c3) - 2\,c3, & -2\,c5\,(d2 + d3\,(-2\,c3\,d2 - 1) + d4\,(-2\,c4\,(d2 + d3\,(-2\,c3\,d2 - 1)) + 2\,c3\,d2 + 1)) + 2\,c4\,(d2 + d3\,(-2\,c3\,d2 - 1)) - 2\,c3\,d2 - 1 \end{bmatrix}$$

**(43)**

The matrix from the second mirror surface to the stop surface is given by:

$$\begin{bmatrix} 1 & 0 \\ -2\,c2 & -1 \end{bmatrix}$$

**(44)**

So as we derived the distance between mirror 5 and 6, we solve this new found value in the appropriate matrix and the vector of distances.

$$d5 := \frac{1}{2}(2\,c6\,d2 - 4\,c6\,d3\,c3\,d2 - 2\,c6\,d3 - 4\,c6\,d4\,c4\,d2 + 8\,c6\,d4\,c4\,d3\,c3\,d2 + 4\,c6\,d4\,c4\,d3 + 4\,c6\,d4\,c3\,d2 + 2\,c6\,d4 - 2\,c5\,d2 + 4\,c5\,d3\,c3\,d2 + 2\,c5\,d3 + 4\,c5\,d4\,c4\,d2$$
$$- 8\,c5\,d4\,c4\,d3\,c3\,d2 - 4\,c5\,d4\,c4\,d3 - 4\,c5\,d4\,c3\,d2 - 2\,c5\,d4 + 2\,c4\,d2 - 4\,c4\,d3\,c3\,d2 - 2\,c4\,d3 - 2\,c3\,d2 - 1)\,/\,($$
$$c6\,(2\,c5\,d2 - 4\,c5\,d3\,c3\,d2 - 2\,c5\,d3 - 4\,c5\,d4\,c4\,d2 + 8\,c5\,d4\,c4\,d3\,c3\,d2 + 4\,c5\,d4\,c4\,d3 + 4\,c5\,d4\,c3\,d2 + 2\,c5\,d4 - 2\,c4\,d2 + 4\,c4\,d3\,c3\,d2 + 2\,c4\,d3 + 2\,c3\,d2 + 1))$$

**(45)**

The distance between mirror one and two is derived as:

$$d1 := -\frac{1}{4}\,\frac{-2\,magn\;yob\;c6 - angle\;(-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) + 2\,c4\,(d2 + d3\,(-2\,c3\,d2 - 1)) - 2\,c3\,d2 - 1)}{c1\;magn\;yob\;c6} \qquad (46)$$

and the distance between the object and the first mirror is:

$$\begin{aligned} d0 := \frac{1}{2}\,(&-angle\;(-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) + 2\,c4\,(d2 + d3\,(-2\,c3\,d2 - 1)) - 2\,c3\,d2 - 1) \\ &- 2\,c1\;yob\;(-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) + 2\,c4\,(d2 + d3\,(-2\,c3\,d2 - 1)) - 2\,c3\,d2 - 1) - 2\,magn\;yob\;c6)\,/\,( \\ &angle\;c1\;(-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) + 2\,c4\,(d2 + d3\,(-2\,c3\,d2 - 1)) - 2\,c3\,d2 - 1)) \end{aligned} \qquad (47)$$

The distance between mirror six and the image surface is:

$$\begin{aligned} d6 := -\frac{1}{4}\,(&2\,angle\,(1 - 2\,d3\,c3 + d4\,(-2\,c4\,(1 - 2\,d3\,c3) + 2\,c3))\,c6\,( \\ &-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) \\ &+ 2\,c4\,(d2 + d3\,(-2\,c3\,d2 - 1)) - 2\,c3\,d2 - 1) - 2\,angle \\ &(-2\,c5\,(1 - 2\,d3\,c3 + d4\,(-2\,c4\,(1 - 2\,d3\,c3) + 2\,c3)) + 2\,c4\,(1 - 2\,d3\,c3) - 2\,c3)\,c6 \\ &(d2 + d3\,(-2\,c3\,d2 - 1) + d4\,(-2\,c4\,(d2 + d3\,(-2\,c3\,d2 - 1)) + 2\,c3\,d2 + 1)) - angle \\ &(-2\,c5\,(1 - 2\,d3\,c3 + d4\,(-2\,c4\,(1 - 2\,d3\,c3) + 2\,c3)) + 2\,c4\,(1 - 2\,d3\,c3) - 2\,c3)\,( \\ &-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) \\ &+ 2\,c4\,(d2 + d3\,(-2\,c3\,d2 - 1)) - 2\,c3\,d2 - 1) + 2\,angle\,( \\ &-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) \\ &+ 2\,c4\,(d2 + d3\,(-2\,c3\,d2 - 1)) - 2\,c3\,d2 - 1)^2\,c2 + 4\,c1\,( \\ &-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) \\ &+ 2\,c4\,(d2 + d3\,(-2\,c3\,d2 - 1)) - 2\,c3\,d2 - 1)\,magn\,yob\,c6 + 4\,magn^2\,yob\,c6^2)\,\Big/\,(( \\ &(-2\,c5\,(1 - 2\,d3\,c3 + d4\,(-2\,c4\,(1 - 2\,d3\,c3) + 2\,c3)) + 2\,c4\,(1 - 2\,d3\,c3) - 2\,c3) \\ &(d2 + d3\,(-2\,c3\,d2 - 1) + d4\,(-2\,c4\,(d2 + d3\,(-2\,c3\,d2 - 1)) + 2\,c3\,d2 + 1)) - ( \\ &-2\,c5\,(d2 + d3\,(-2\,c3\,d2 - 1) + d4\,(-2\,c4\,(d2 + d3\,(-2\,c3\,d2 - 1)) + 2\,c3\,d2 + 1)) \\ &+ 2\,c4\,(d2 + d3\,(-2\,c3\,d2 - 1)) - 2\,c3\,d2 - 1)\,(1 - 2\,d3\,c3 + d4\,(-2\,c4\,(1 - 2\,d3\,c3) + 2\,c3))) \\ &c6^2\,angle) \end{aligned} \qquad (48)$$

The variable *angle* is identical to *ya* introduced in equation (24) above.

<u>6-mirror system, stop on mirror 3</u>

The original derivations can similarly be used to solve the variables of a six-mirror system with the stop position on mirror three, as will now be shown.

The first solve is pupil in infinity or telecentricity in the image. The angle of the ray going through the optical axis in the stop surface should be zero in the image. The matrix from the stop surface to the fifth mirror generated by multiplication of the appropriate M matrices derived just above, is given by:

$$\begin{bmatrix} 1-2\,d4\,c4 & d3+d4\,(-2\,c4\,d3-1) \\ -2\,c5\,(1-2\,d4\,c4)+2\,c4 & -2\,c5\,(d3+d4\,(-2\,c4\,d3-1))+2\,c4\,d3+1 \end{bmatrix} \quad (50)$$

The matrix from the second mirror surface to the stop surface is given by:

$$\begin{bmatrix} 1-2\,d2\,c2 & -d2 \\ -2\,c3\,(1-2\,d2\,c2)+2\,c2 & 2\,c3\,d2+1 \end{bmatrix} \quad (51)$$

So, as derived above, the distance between mirror 5 and 6 is, solved this new found value in the appropriate matrix and the vector of distances:

$$d5 := -\frac{1}{2}\,\frac{2\,c6\,d3-4\,c6\,d4\,c4\,d3-2\,c6\,d4-2\,c5\,d3+4\,c5\,d4\,c4\,d3+2\,c5\,d4+2\,c4\,d3+1}{c6\,(-2\,c5\,d3+4\,c5\,d4\,c4\,d3+2\,c5\,d4+2\,c4\,d3+1)} \quad (51)$$

The distance between mirror one and two was:

$$\begin{aligned} d1 := -\frac{1}{4}\big(&-4\,d2\,c1\,magn\,yob\,c6-2\,(1-2\,d2\,c2)\,magn\,yob\,c6+(1-2\,d2\,c2)\,angle\,(-2\,c5\,(d3+d4\,(-2\,c4\,d3-1))+2\,c4\,d3+1)\,(2\,c3\,d2+1) \\ &+angle\,d2\,(-2\,c5\,(d3+d4\,(-2\,c4\,d3-1))+2\,c4\,d3+1)\,(-2\,c3\,(1-2\,d2\,c2)+2\,c2)\big)\,/\,((1-2\,d2\,c2)\,c1\,magn\,yob\,c6) \end{aligned} \quad (52)$$

And the distance between the object and the first mirror:

$$\begin{aligned} d0 := -\frac{1}{2}\big((&1-2\,d2\,c2)\,angle\,(-2\,c5\,(d3+d4\,(-2\,c4\,d3-1))+2\,c4\,d3+1)\,(2\,c3\,d2+1) \\ &+angle\,d2\,(-2\,c5\,(d3+d4\,(-2\,c4\,d3-1))+2\,c4\,d3+1)\,(-2\,c3\,(1-2\,d2\,c2)+2\,c2) \\ &+2\,c1\,yob\,d2\,(-2\,c5\,(d3+d4\,(-2\,c4\,d3-1))+2\,c4\,d3+1)\,(-2\,c3\,(1-2\,d2\,c2)+2\,c2) \\ &+2\,c1\,yob\,(1-2\,d2\,c2)\,(-2\,c5\,(d3+d4\,(-2\,c4\,d3-1))+2\,c4\,d3+1)\,(2\,c3\,d2+1) \\ &-2\,(1-2\,d2\,c2)\,magn\,yob\,c6\big)\,/\,(angle\,((-2\,c3\,(1-2\,d2\,c2)+2\,c2)\,d2 \\ &+(2\,c3\,d2+1)\,(1-2\,d2\,c2))\,c1\,(-2\,c5\,(d3+d4\,(-2\,c4\,d3-1))+2\,c4\,d3+1)) \end{aligned} \quad (53)$$

And the distance between mirror six and the image surface:

$$d6 := -\frac{1}{4}(-2\, angle\,(1-2\,d2\,c2)^2\,(1-2\,d4\,c4)\,c6\,(-2\,c5\,(d3+d4\,(-2\,c4\,d3-1))+2\,c4\,d3+1)\,(2\,c3\,d2+1) - 2\,angle\,(1-2\,d2\,c2)\,(1-2\,d4\,c4)\,c6\,(-2\,c5\,(d3+d4\,(-2\,c4\,d3-1))+2\,c4\,d3+1)\,d2\,(-2\,c3\,(1-2\,d2\,c2)+2\,c2) + 2\,angle\,(1-2\,d2\,c2)^2\,(-2\,c5\,(1-2\,d4\,c4)+2\,c4)\,c6\,(d3+d4\,(-2\,c4\,d3-1))\,(2\,c3\,d2+1) + 2\,angle\,(1-2\,d2\,c2)\,(-2\,c5\,(1-2\,d4\,c4)+2\,c4)\,c6\,(d3+d4\,(-2\,c4\,d3-1))\,d2\,(-2\,c3\,(1-2\,d2\,c2)+2\,c2) + angle\,(1-2\,d2\,c2)^2\,(-2\,c5\,(1-2\,d4\,c4)+2\,c4)\,(-2\,c5\,(d3+d4\,(-2\,c4\,d3-1))+2\,c4\,d3+1)\,(2\,c3\,d2+1) + angle\,(1-2\,d2\,c2)\,(-2\,c5\,(1-2\,d4\,c4)+2\,c4)\,(-2\,c5\,(d3+d4\,(-2\,c4\,d3-1))+2\,c4\,d3+1)\,d2\,(-2\,c3\,(1-2\,d2\,c2)+2\,c2) + angle\,(-2\,c5\,(d3+d4\,(-2\,c4\,d3-1))+2\,c4\,d3+1)^2\,(-2\,c3\,(1-2\,d2\,c2)+2\,c2)\,(1-2\,d2\,c2)\,(2\,c3\,d2+1) + angle\,(-2\,c5\,(d3+d4\,(-2\,c4\,d3-1))+2\,c4\,d3+1)^2\,(-2\,c3\,(1-2\,d2\,c2)+2\,c2)^2\,d2 - 4\,(-2\,c5\,(d3+d4\,(-2\,c4\,d3-1))+2\,c4\,d3+1)\,(-2\,c3\,(1-2\,d2\,c2)+2\,c2)\,d2\,c1\,magn\,yob\,c6 - 4\,c1\,(-2\,c5\,(d3+d4\,(-2\,c4\,d3-1))+2\,c4\,d3+1)\,(2\,c3\,d2+1)\,(1-2\,d2\,c2)\,magn\,yob\,c6 + 4\,magn^2\,yob\,c6^2\,(1-2\,d2\,c2))\Big/((\,(-2\,c5\,(d3+d4\,(-2\,c4\,d3-1))+2\,c4\,d3+1)\,(1-2\,d4\,c4)\,d2\,(-2\,c3\,(1-2\,d2\,c2)+2\,c2) - (-2\,c5\,(1-2\,d4\,c4)+2\,c4)\,(d3+d4\,(-2\,c4\,d3-1))\,d2\,(-2\,c3\,(1-2\,d2\,c2)+2\,c2) - (2\,c3\,d2+1)\,(1-2\,d2\,c2)\,(-2\,c5\,(1-2\,d4\,c4)+2\,c4)\,(d3+d4\,(-2\,c4\,d3-1)) + (2\,c3\,d2+1)\,(1-2\,d2\,c2)\,(-2\,c5\,(d3+d4\,(-2\,c4\,d3-1))+2\,c4\,d3+1)\,(1-2\,d4\,c4))\,(1-2\,d2\,c2)\,c6^2\,angle) \quad (54)$$

6-mirror system, stop on mirror 4

Similarly, the original derivations can be used to solve the variables of a six-mirror system with the stop position on mirror four.

Again, the first solve is pupil in infinity or telecentricity in the image. The angle of the ray going through the optical axis in the stop surface should be zero in the image. The matrix from the stop surface to the fifth mirror generated by multiplication of the appropriate M matrices derived above is given by:

$$\begin{bmatrix} 1 & d4 \\ -2\,c5 & -2\,c5\,d4-1 \end{bmatrix} \quad (55)$$

The matrix from the second mirror surface to the stop surface is given by:

$$\begin{bmatrix} 1-2\,d2\,c2+d3\,(-2\,c3\,(1-2\,d2\,c2)+2\,c2) & -d2+d3\,(2\,c3\,d2+1) \\ -2\,c4\,(1-2\,d2\,c2+d3\,(-2\,c3\,(1-2\,d2\,c2)+2\,c2))+2\,c3\,(1-2\,d2\,c2)-2\,c2 & -2\,c4\,(-d2+d3\,(2\,c3\,d2+1))-2\,c3\,d2-1 \end{bmatrix} \quad (56)$$

So, as derived above, the distance between mirror 5 and 6, solved in the appropriate matrix and the vector of distances, is:

$$d5 := -\frac{1}{2}\frac{-2\,c6\,d4 + 2\,c5\,d4 + 1}{c6\,(2\,c5\,d4 + 1)} \tag{57}$$

The distance between mirror one and two is:

$$\begin{aligned} d1 := -\frac{1}{4}(&4\,(-d2 + d3\,(2\,c3\,d2 + 1))\,c1\,magn\,yob\,c6 - 2\,(1 - 2\,d2\,c2 + d3\,(-2\,c3\,(1 - 2\,d2\,c2) + 2\,c2))\,magn\,yob\,c6 \\ &+ (1 - 2\,d2\,c2 + d3\,(-2\,c3\,(1 - 2\,d2\,c2) + 2\,c2))\,angle\,(-2\,c5\,d4 - 1)\,(-2\,c4\,(-d2 + d3\,(2\,c3\,d2 + 1)) - 2\,c3\,d2 - 1) \\ &- angle\,(-d2 + d3\,(2\,c3\,d2 + 1))\,(-2\,c5\,d4 - 1)\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\,/\,( \\ &(1 - 2\,d2\,c2 + d3\,(-2\,c3\,(1 - 2\,d2\,c2) + 2\,c2))\,c1\,magn\,yob\,c6) \end{aligned} \tag{58}$$

And the distance between the object and the first mirror:

$$\begin{aligned} d0 := -\frac{1}{2}(&(1 - 2\,d2\,c2 + d3\,(-2\,c3\,(1 - 2\,d2\,c2) + 2\,c2))\,angle\,(-2\,c5\,d4 - 1)\,(-2\,c4\,(-d2 + d3\,(2\,c3\,d2 + 1)) - 2\,c3\,d2 - 1) \\ &- angle\,(-d2 + d3\,(2\,c3\,d2 + 1))\,(-2\,c5\,d4 - 1)\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2) \\ &- 2\,c1\,yob\,(-d2 + d3\,(2\,c3\,d2 + 1))\,(-2\,c5\,d4 - 1)\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2) \\ &+ 2\,c1\,yob\,(1 - 2\,d2\,c2 + d3\,(-2\,c3\,(1 - 2\,d2\,c2) + 2\,c2))\,(-2\,c5\,d4 - 1)\,(-2\,c4\,(-d2 + d3\,(2\,c3\,d2 + 1)) - 2\,c3\,d2 - 1) \\ &- 2\,(1 - 2\,d2\,c2 + d3\,(-2\,c3\,(1 - 2\,d2\,c2) + 2\,c2))\,magn\,yob\,c6) \\ &/\,(angle\,(-(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2)\,(-d2 + d3\,(2\,c3\,d2 + 1)) \\ &+ (-2\,c4\,(-d2 + d3\,(2\,c3\,d2 + 1)) - 2\,c3\,d2 - 1)\,(1 - 2\,d2\,c2 + d3\,(-2\,c3\,(1 - 2\,d2\,c2) + 2\,c2)))\,c1\,(-2\,c5\,d4 - 1)) \end{aligned} \tag{59}$$

And the distance between mirror six and the image surface:

$$d6 := -\frac{1}{4}(-2\,angle\,(1-2\,d2\,c2+d3\,(-2\,c3\,(1-2\,d2\,c2)+2\,c2))^2\,c6\,(-2\,c5\,d4-1)$$
$$(-2\,c4\,(-d2+d3\,(2\,c3\,d2+1))-2\,c3\,d2-1)+2\,angle$$
$$(1-2\,d2\,c2+d3\,(-2\,c3\,(1-2\,d2\,c2)+2\,c2))\,c6\,(-2\,c5\,d4-1)\,(-d2+d3\,(2\,c3\,d2+1))$$
$$(-2\,c4\,(1-2\,d2\,c2+d3\,(-2\,c3\,(1-2\,d2\,c2)+2\,c2))+2\,c3\,(1-2\,d2\,c2)-2\,c2)-4\,angle$$
$$(1-2\,d2\,c2+d3\,(-2\,c3\,(1-2\,d2\,c2)+2\,c2))^2\,c5\,c6\,d4$$
$$(-2\,c4\,(-d2+d3\,(2\,c3\,d2+1))-2\,c3\,d2-1)+4\,angle$$
$$(1-2\,d2\,c2+d3\,(-2\,c3\,(1-2\,d2\,c2)+2\,c2))\,c5\,c6\,d4\,(-d2+d3\,(2\,c3\,d2+1))$$
$$(-2\,c4\,(1-2\,d2\,c2+d3\,(-2\,c3\,(1-2\,d2\,c2)+2\,c2))+2\,c3\,(1-2\,d2\,c2)-2\,c2)-2\,angle$$
$$(1-2\,d2\,c2+d3\,(-2\,c3\,(1-2\,d2\,c2)+2\,c2))^2\,c5\,(-2\,c5\,d4-1)$$
$$(-2\,c4\,(-d2+d3\,(2\,c3\,d2+1))-2\,c3\,d2-1)+2\,angle$$
$$(1-2\,d2\,c2+d3\,(-2\,c3\,(1-2\,d2\,c2)+2\,c2))\,c5\,(-2\,c5\,d4-1)\,(-d2+d3\,(2\,c3\,d2+1))$$
$$(-2\,c4\,(1-2\,d2\,c2+d3\,(-2\,c3\,(1-2\,d2\,c2)+2\,c2))+2\,c3\,(1-2\,d2\,c2)-2\,c2)+angle$$
$$(-2\,c5\,d4-1)^2\,(-2\,c4\,(1-2\,d2\,c2+d3\,(-2\,c3\,(1-2\,d2\,c2)+2\,c2))+2\,c3\,(1-2\,d2\,c2)-2\,c2)$$
$$(1-2\,d2\,c2+d3\,(-2\,c3\,(1-2\,d2\,c2)+2\,c2))\,(-2\,c4\,(-d2+d3\,(2\,c3\,d2+1))-2\,c3\,d2-1)-$$
$$angle\,(-2\,c5\,d4-1)^2$$
$$(-2\,c4\,(1-2\,d2\,c2+d3\,(-2\,c3\,(1-2\,d2\,c2)+2\,c2))+2\,c3\,(1-2\,d2\,c2)-2\,c2)^2$$
$$(-d2+d3\,(2\,c3\,d2+1))+4\,(-2\,c5\,d4-1)$$
$$(-2\,c4\,(1-2\,d2\,c2+d3\,(-2\,c3\,(1-2\,d2\,c2)+2\,c2))+2\,c3\,(1-2\,d2\,c2)-2\,c2)$$
$$(-d2+d3\,(2\,c3\,d2+1))\,c1\,magn\,yob\,c6-4\,c1\,(-2\,c5\,d4-1)$$
$$(-2\,c4\,(-d2+d3\,(2\,c3\,d2+1))-2\,c3\,d2-1)\,(1-2\,d2\,c2+d3\,(-2\,c3\,(1-2\,d2\,c2)+2\,c2))$$
$$magn\,yob\,c6+4\,magn^2\,yob\,c6^2\,(1-2\,d2\,c2+d3\,(-2\,c3\,(1-2\,d2\,c2)+2\,c2)))\Big/((-$$
$$(-2\,c5\,d4-1)\,(-d2+d3\,(2\,c3\,d2+1))$$
$$(-2\,c4\,(1-2\,d2\,c2+d3\,(-2\,c3\,(1-2\,d2\,c2)+2\,c2))+2\,c3\,(1-2\,d2\,c2)-2\,c2)-2\,c5\,d4$$
$$(-d2+d3\,(2\,c3\,d2+1))$$
$$(-2\,c4\,(1-2\,d2\,c2+d3\,(-2\,c3\,(1-2\,d2\,c2)+2\,c2))+2\,c3\,(1-2\,d2\,c2)-2\,c2)+2$$
$$(-2\,c4\,(-d2+d3\,(2\,c3\,d2+1))-2\,c3\,d2-1)\,(1-2\,d2\,c2+d3\,(-2\,c3\,(1-2\,d2\,c2)+2\,c2))\,c5$$
$$d4+(-2\,c4\,(-d2+d3\,(2\,c3\,d2+1))-2\,c3\,d2-1)$$
$$(1-2\,d2\,c2+d3\,(-2\,c3\,(1-2\,d2\,c2)+2\,c2))\,(-2\,c5\,d4-1))$$
$$(1-2\,d2\,c2+d3\,(-2\,c3\,(1-2\,d2\,c2)+2\,c2))\,c6^2\,angle) \quad \textbf{(60)}$$

6-mirror system, stop on mirror 5

Again, we use the original derivations to solve the variables of a six-mirror system with the stop position on mirror five. As before, the first solve is pupil in infinity or telecentricity in the image. The angle of the ray going through the optical axis in the stop surface should be zero in the image. The matrix from the stop surface to the fifth mirror generated by multiplication of the appropriate M matrices derived above is given by:

$$\begin{bmatrix} 1 & 0 \\ 0 & 1 \end{bmatrix} \quad \textbf{(61)}$$

The matrix from the second mirror surface to the stop surface is given by:

$$\begin{aligned}&[1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2),\\ &\quad -d2 + d3\,(2\,c3\,d2 + 1) + d4\,(-2\,c4\,(-d2 + d3\,(2\,c3\,d2 + 1)) - 2\,c3\,d2 - 1)]\\ &\quad [-2\,c5\,(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\\ &\quad + 2\,c4\,(1 - 2\,d2\,c2 + d3\,(-2\,c3\,(1 - 2\,d2\,c2) + 2\,c2)) - 2\,c3\,(1 - 2\,d2\,c2) + 2\,c2,\\ &\quad -2\,c5\,(-d2 + d3\,(2\,c3\,d2 + 1) + d4\,(-2\,c4\,(-d2 + d3\,(2\,c3\,d2 + 1)) - 2\,c3\,d2 - 1)) + 2\,c4\,(-d2 + d3\,(2\,c3\,d2 + 1)) + 2\,c3\,d2 + 1]\end{aligned} \tag{62}$$

So, as derived above, the distance between mirror 5 and 6, solved in the appropriate matrix and the vector of distances: is:

$$d5 := -\frac{1}{2}\frac{1}{c6} \tag{63}$$

The distance between mirror one and two was:

$$\begin{aligned}&d1 := -\frac{1}{4}(4\,(-d2 + d3\,(2\,c3\,d2 + 1) + d4\,(-2\,c4\,(-d2 + d3\,(2\,c3\,d2 + 1)) - 2\,c3\,d2 - 1))\,c1\,magn\,\,yob\,\,c6\\ &\quad - 2\,(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\,magn\,\,yob\,\,c6 +\\ &\quad (1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\,angle\\ &\quad (-2\,c5\,(-d2 + d3\,(2\,c3\,d2 + 1) + d4\,(-2\,c4\,(-d2 + d3\,(2\,c3\,d2 + 1)) - 2\,c3\,d2 - 1)) + 2\,c4\,(-d2 + d3\,(2\,c3\,d2 + 1)) + 2\,c3\,d2 + 1) - angle\\ &\quad (-d2 + d3\,(2\,c3\,d2 + 1) + d4\,(-2\,c4\,(-d2 + d3\,(2\,c3\,d2 + 1)) - 2\,c3\,d2 - 1))\,(\\ &\quad -2\,c5\,(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\\ &\quad + 2\,c4\,(1 - 2\,d2\,c2 + d3\,(-2\,c3\,(1 - 2\,d2\,c2) + 2\,c2)) - 2\,c3\,(1 - 2\,d2\,c2) + 2\,c2))\,/\,(\\ &\quad (1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\,c1\,magn\,\,yob\,\,c6)\end{aligned} \tag{64}$$

And the distance between the object and the first mirror:

$$
\begin{aligned}
d0 := -\frac{1}{2}&((1 - 2\, d2\, c2 + d3\, (-2\, c3\, (1 - 2\, d2\, c2) + 2\, c2) \\
&+ d4\, (-2\, c4\, (1 - 2\, d2\, c2 + d3\, (-2\, c3\, (1 - 2\, d2\, c2) + 2\, c2)) + 2\, c3\, (1 - 2\, d2\, c2) - 2\, c2))\, \mathit{angle} \\
&(-2\, c5\, (-d2 + d3\, (2\, c3\, d2 + 1) + d4\, (-2\, c4\, (-d2 + d3\, (2\, c3\, d2 + 1)) - 2\, c3\, d2 - 1)) \\
&+ 2\, c4\, (-d2 + d3\, (2\, c3\, d2 + 1)) + 2\, c3\, d2 + 1) \\
&- \mathit{angle}\, (-d2 + d3\, (2\, c3\, d2 + 1) + d4\, (-2\, c4\, (-d2 + d3\, (2\, c3\, d2 + 1)) - 2\, c3\, d2 - 1)) \\
&(-2\, c5\, (1 - 2\, d2\, c2 + d3\, (-2\, c3\, (1 - 2\, d2\, c2) + 2\, c2) \\
&+ d4\, (-2\, c4\, (1 - 2\, d2\, c2 + d3\, (-2\, c3\, (1 - 2\, d2\, c2) + 2\, c2)) + 2\, c3\, (1 - 2\, d2\, c2) - 2\, c2)) \\
&+ 2\, c4\, (1 - 2\, d2\, c2 + d3\, (-2\, c3\, (1 - 2\, d2\, c2) + 2\, c2)) - 2\, c3\, (1 - 2\, d2\, c2) + 2\, c2) \\
&- 2\, c1\, \mathit{yob}\, (-d2 + d3\, (2\, c3\, d2 + 1) + d4\, (-2\, c4\, (-d2 + d3\, (2\, c3\, d2 + 1)) - 2\, c3\, d2 - 1)) \\
&(-2\, c5\, (1 - 2\, d2\, c2 + d3\, (-2\, c3\, (1 - 2\, d2\, c2) + 2\, c2) \\
&+ d4\, (-2\, c4\, (1 - 2\, d2\, c2 + d3\, (-2\, c3\, (1 - 2\, d2\, c2) + 2\, c2)) + 2\, c3\, (1 - 2\, d2\, c2) - 2\, c2)) \\
&+ 2\, c4\, (1 - 2\, d2\, c2 + d3\, (-2\, c3\, (1 - 2\, d2\, c2) + 2\, c2)) - 2\, c3\, (1 - 2\, d2\, c2) + 2\, c2) + 2\, c1\, \mathit{yob} \\
&(1 - 2\, d2\, c2 + d3\, (-2\, c3\, (1 - 2\, d2\, c2) + 2\, c2) + \\
&d4\, (-2\, c4\, (1 - 2\, d2\, c2 + d3\, (-2\, c3\, (1 - 2\, d2\, c2) + 2\, c2)) + 2\, c3\, (1 - 2\, d2\, c2) - 2\, c2)) \\
&(-2\, c5\, (-d2 + d3\, (2\, c3\, d2 + 1) + d4\, (-2\, c4\, (-d2 + d3\, (2\, c3\, d2 + 1)) - 2\, c3\, d2 - 1)) \\
&+ 2\, c4\, (-d2 + d3\, (2\, c3\, d2 + 1)) + 2\, c3\, d2 + 1) - 2\, (1 - 2\, d2\, c2 + d3\, (-2\, c3\, (1 - 2\, d2\, c2) + 2\, c2) \\
&+ d4\, (-2\, c4\, (1 - 2\, d2\, c2 + d3\, (-2\, c3\, (1 - 2\, d2\, c2) + 2\, c2)) + 2\, c3\, (1 - 2\, d2\, c2) - 2\, c2))\, \mathit{magn}\, \mathit{yob}\, c6) \\
&/\, (\mathit{angle}\, (-(-2\, c5\, (1 - 2\, d2\, c2 + d3\, (-2\, c3\, (1 - 2\, d2\, c2) + 2\, c2) \\
&+ d4\, (-2\, c4\, (1 - 2\, d2\, c2 + d3\, (-2\, c3\, (1 - 2\, d2\, c2) + 2\, c2)) + 2\, c3\, (1 - 2\, d2\, c2) - 2\, c2)) \\
&+ 2\, c4\, (1 - 2\, d2\, c2 + d3\, (-2\, c3\, (1 - 2\, d2\, c2) + 2\, c2)) - 2\, c3\, (1 - 2\, d2\, c2) + 2\, c2) \\
&(-d2 + d3\, (2\, c3\, d2 + 1) + d4\, (-2\, c4\, (-d2 + d3\, (2\, c3\, d2 + 1)) - 2\, c3\, d2 - 1)) \\
&+ (-2\, c5\, (-d2 + d3\, (2\, c3\, d2 + 1) + d4\, (-2\, c4\, (-d2 + d3\, (2\, c3\, d2 + 1)) - 2\, c3\, d2 - 1)) \\
&+ 2\, c4\, (-d2 + d3\, (2\, c3\, d2 + 1)) + 2\, c3\, d2 + 1)(1 - 2\, d2\, c2 + d3\, (-2\, c3\, (1 - 2\, d2\, c2) + 2\, c2) \\
&+ d4\, (-2\, c4\, (1 - 2\, d2\, c2 + d3\, (-2\, c3\, (1 - 2\, d2\, c2) + 2\, c2)) + 2\, c3\, (1 - 2\, d2\, c2) - 2\, c2)))\, c1)
\end{aligned}
\tag{65}
$$

And the distance between mirror six and the image surface:

$$\begin{aligned}
&d6 := -\frac{1}{4}(-2\,angle\\
&(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))^2\,c6\\
&(-2\,c5\,(-d2 + d3\,(2\,c3\,d2 + 1) + d4\,(-2\,c4\,(-d2 + d3\,(2\,c3\,d2 + 1)) - 2\,c3\,d2 - 1)) + 2\,c4\,(-d2 + d3\,(2\,c3\,d2 + 1)) + 2\,c3\,d2 + 1) + 2\,angle\\
&(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\,c6\\
&(-d2 + d3\,(2\,c3\,d2 + 1) + d4\,(-2\,c4\,(-d2 + d3\,(2\,c3\,d2 + 1)) - 2\,c3\,d2 - 1))\,(\\
&-2\,c5\,(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\\
&\quad + 2\,c4\,(1 - 2\,d2\,c2 + d3\,(-2\,c3\,(1 - 2\,d2\,c2) + 2\,c2)) - 2\,c3\,(1 - 2\,d2\,c2) + 2\,c2) + angle\,(\\
&-2\,c5\,(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\\
&\quad + 2\,c4\,(1 - 2\,d2\,c2 + d3\,(-2\,c3\,(1 - 2\,d2\,c2) + 2\,c2)) - 2\,c3\,(1 - 2\,d2\,c2) + 2\,c2)\\
&(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\\
&(-2\,c5\,(-d2 + d3\,(2\,c3\,d2 + 1) + d4\,(-2\,c4\,(-d2 + d3\,(2\,c3\,d2 + 1)) - 2\,c3\,d2 - 1)) + 2\,c4\,(-d2 + d3\,(2\,c3\,d2 + 1)) + 2\,c3\,d2 + 1) - angle\,(\\
&-2\,c5\,(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\\
&\quad + 2\,c4\,(1 - 2\,d2\,c2 + d3\,(-2\,c3\,(1 - 2\,d2\,c2) + 2\,c2)) - 2\,c3\,(1 - 2\,d2\,c2) + 2\,c2)^2\\
&(-d2 + d3\,(2\,c3\,d2 + 1) + d4\,(-2\,c4\,(-d2 + d3\,(2\,c3\,d2 + 1)) - 2\,c3\,d2 - 1)) + 4\,(\\
&-2\,c5\,(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\\
&\quad + 2\,c4\,(1 - 2\,d2\,c2 + d3\,(-2\,c3\,(1 - 2\,d2\,c2) + 2\,c2)) - 2\,c3\,(1 - 2\,d2\,c2) + 2\,c2)\\
&(-d2 + d3\,(2\,c3\,d2 + 1) + d4\,(-2\,c4\,(-d2 + d3\,(2\,c3\,d2 + 1)) - 2\,c3\,d2 - 1))\,c1\,magn\,yoh\,c6 - 4\,c1\\
&(-2\,c5\,(-d2 + d3\,(2\,c3\,d2 + 1) + d4\,(-2\,c4\,(-d2 + d3\,(2\,c3\,d2 + 1)) - 2\,c3\,d2 - 1)) + 2\,c4\,(-d2 + d3\,(2\,c3\,d2 + 1)) + 2\,c3\,d2 + 1)\\
&(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\,magn\,yoh\,c6\\
&\quad + 4\,magn^2\,yoh\,c6^2\\
&(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2)))\Big/((-(\\
&-2\,c5\,(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\\
&\quad + 2\,c4\,(1 - 2\,d2\,c2 + d3\,(-2\,c3\,(1 - 2\,d2\,c2) + 2\,c2)) - 2\,c3\,(1 - 2\,d2\,c2) + 2\,c2)\\
&(-d2 + d3\,(2\,c3\,d2 + 1) + d4\,(-2\,c4\,(-d2 + d3\,(2\,c3\,d2 + 1)) - 2\,c3\,d2 - 1)) +\\
&(-2\,c5\,(-d2 + d3\,(2\,c3\,d2 + 1) + d4\,(-2\,c4\,(-d2 + d3\,(2\,c3\,d2 + 1)) - 2\,c3\,d2 - 1)) + 2\,c4\,(-d2 + d3\,(2\,c3\,d2 + 1)) + 2\,c3\,d2 + 1)\\
&(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2)))\\
&(1 - 2\,d2\,c2 + d3\,(-2\,c3\,(1 - 2\,d2\,c2) + 2\,c2) + d4\,(-2\,c4\,(1 - 2\,d2\,c2 + d3\,(-2\,c3\,(1 - 2\,d2\,c2) + 2\,c2)) + 2\,c3\,(1 - 2\,d2\,c2) - 2\,c2))\,c6^2\,angle)
\end{aligned}$$

**(66)**

4-mirror system, stop on mirror 2

Yet again, we can use these derivations to solve the variables of a four-mirror system with the stop position on mirror two. As usual, the first solve is pupil in infinity or telecentricity in the image. The angle of the ray going through the optical axis in the stop surface should be zero in the image. The matrix from the stop surface to the third mirror generated by multiplication of the appropriate M matrices derived above, is given by:

$$\begin{bmatrix} 1 & d2 \\ -2\,c3 & -2\,c3\,d2 - 1 \end{bmatrix}$$

**(67)**

The matrix from the second mirror surface to the stop surface is given by:

$$\begin{bmatrix} 1 & 0 \\ -2\,c2 & -1 \end{bmatrix}$$

**(68)**

So as derived above, the distance between mirror 3 and 4, solved in the appropriate matrix and the vector of distances is:

$$d3 := -\frac{1}{2}\,\frac{-2\,c4\,d2 + 2\,c3\,d2 + 1}{c4\,(2\,c3\,d2 + 1)}$$

**(69)**

The distance between mirror one and two was:

$$d1 := -\frac{1}{4}\frac{-2\ magn\ yob\ c4 - angle\ (-2\ c3\ d2 - 1)}{c1\ magn\ yob\ c4} \quad (70)$$

And the distance between the object and the first mirror:

$$d0 := \frac{1}{2}\frac{-angle\ (-2\ c3\ d2 - 1) - 2\ c1\ yob\ (-2\ c3\ d2 - 1) - 2\ magn\ yob\ c4}{angle\ c1\ (-2\ c3\ d2 - 1)} \quad (71)$$

And the distance between mirror four and the image surface:

$$d4 := -\frac{1}{4}(2\ angle\ c4\ (-2\ c3\ d2 - 1) + 4\ angle\ c3\ c4\ d2 + 2\ angle\ c3\ (-2\ c3\ d2 - 1) + 2\ angle\ (-2\ c3\ d2 - 1)^2\ c2 + 4\ c1\ (-2\ c3\ d2 - 1)\ magn\ yob\ c4 + 4\ magn^2\ yob\ c4^2) \big/ (c4^2\ angle) \quad (72)$$

4-mirror system, stop on mirror 3

Again, we use the original derivations to solve the variables of a four-mirror system with the stop position on mirror three. The first solve is pupil in infinity or telecentricity in the image. The angle of the ray going through the optical axis in the stop surface should be zero in the image. The matrix from the stop surface to the third mirror generated by multiplication of the appropriate M matrices derived above is given by:

$$\begin{bmatrix} 1 & 0 \\ 0 & 1 \end{bmatrix} \quad (73)$$

The matrix from the second mirror surface to the stop surface is given by:

$$\begin{bmatrix} 1 - 2\ d2\ c2 & -d2 \\ -2\ c3\ (1 - 2\ d2\ c2) + 2\ c2 & 2\ c3\ d2 + 1 \end{bmatrix} \quad (74)$$

So as we derived the distance between mirror 3 and 4 is:

$$d3 := -\frac{1}{2}\frac{1}{c4} \quad (75)$$

And we solve this new found value in the appropriate matrix and the vector of distances.
The distance between mirror one and two was:

$$d1 := -\frac{1}{4}\frac{-4\,d2\,c1\,magn\,yob\,c4 - 2\,(1-2\,d2\,c2)\,magn\,yob\,c4 + (1-2\,d2\,c2)\,angle\,(2\,c3\,d2+1) + angle\,d2\,(-2\,c3\,(1-2\,d2\,c2)+2\,c2)}{(1-2\,d2\,c2)\,c1\,magn\,yob\,c4} \quad (76)$$

And the distance between the object and the first mirror:

$$\begin{aligned} d0 := -\frac{1}{2}(&(1-2\,d2\,c2)\,angle\,(2\,c3\,d2+1) + angle\,d2\,(-2\,c3\,(1-2\,d2\,c2)+2\,c2) \\ &+ 2\,c1\,yob\,d2\,(-2\,c3\,(1-2\,d2\,c2)+2\,c2) + 2\,c1\,yob\,(1-2\,d2\,c2)\,(2\,c3\,d2+1) \\ &- 2\,(1-2\,d2\,c2)\,magn\,yob\,c4\,) \\ &/\,(angle\,((-2\,c3\,(1-2\,d2\,c2)+2\,c2)\,d2 + (2\,c3\,d2+1)\,(1-2\,d2\,c2))\,c1\,) \end{aligned} \quad (77)$$

And the distance between mirror four and the image surface:

$$\begin{aligned} d4 := -\frac{1}{4}(&-2\,angle\,(1-2\,d2\,c2)^2\,c4\,(2\,c3\,d2+1) \\ &-2\,angle\,(1-2\,d2\,c2)\,c4\,d2\,(-2\,c3\,(1-2\,d2\,c2)+2\,c2) \\ &+angle\,(-2\,c3\,(1-2\,d2\,c2)+2\,c2)\,(1-2\,d2\,c2)\,(2\,c3\,d2+1) \\ &+angle\,(-2\,c3\,(1-2\,d2\,c2)+2\,c2)^2\,d2 - 4\,(-2\,c3\,(1-2\,d2\,c2)+2\,c2)\,d2\,c1\,magn\,yob\,c4 \\ &-4\,c1\,(2\,c3\,d2+1)\,(1-2\,d2\,c2)\,magn\,yob\,c4 + 4\,magn^2\,yob\,c4^2\,(1-2\,d2\,c2))\,/\,( \\ &((-2\,c3\,(1-2\,d2\,c2)+2\,c2)\,d2 + (2\,c3\,d2+1)\,(1-2\,d2\,c2))\,(1-2\,d2\,c2)\,c4^2\,angle\,) \end{aligned} \quad (78)$$

Obscuration

A particular problem in designing mirror systems, not encountered in refractive lens systems, is ensuring that the beam is not obscured in its zigzag course by other mirrors. Because of the necessary zigzag path, as the projection beam proceeds between successive mirrors I and I+1 on the optical path in many cases it will pass by at least one other mirror J. Thus, for an optical system not to be obscured it is necessary to ensure that the position and extent of the intervening mirror J is such that it does not intersect any part of the beam between mirrors I and I+1. This is shown in Figure 4 in which it can be seen that mirror J lies wholly below the beam between I and I+1 whereas mirror J' partially intersects the beam. The arrangement of mirror J is not permitted.

In a model of a potential projection system, obscuration can be detected by the following procedure:

1. For each pair of successive mirrors I, I+1 on the optical path, check if there exists a mirror J (with J not equal to I, I+1) having a position on the optical axis (Z axis) between I and I+1

2. If J exists, calculate the distance from the optical axis (Y position) of the extreme rays from I to I+1 at the position of mirror J on the optical axis.

3. Check that the top and bottom of mirror J are both above (i.e. have greater Y position) or both below (i.e. have smaller Y position) both the extreme rays from I to I+1.
If the check in (3) fails, then mirror J at least partially obscures the beam from I to I+1 and the mirror system must be modified or rejected.

Preferred four-mirror systems

Figure 6 shows a mirror system in class 9(+) which can be used in the lithography apparatus of Figure 1. In this class, the stop can be positioned on mirror 2 or 3; in the system of Figure 6, the stop position is on surface 2. The ring field of this system is defined on the object side, between 114 and 118 arbitrary units, with a numerical aperture of 0.25 (0.05 on the object side). The magnification is 0.2 and an intermediate image is formed between mirrors 3 and 4. The first order curvatures and thicknesses of this system, in arbitrary units, are given in Table 1 below. The values found for the curvatures and thicknesses can be re-scaled using a scaling factor. If the thicknesses are multiplied by that factor, the curvatures should be divided by it, and vice versa.
Figure 7 also shows a mirror system in class 9(+). In this case the stop is on mirror 3 and the intermediate image is between mirrors 1 and 2. The first order curvatures and thicknesses of this system, in arbitrary units, are given in Table 2 below.
Figure 8 shows an example of a class 2(-) system having the stop located on the third mirror. From the object (mask MA, surface 0) all the rays go, with a negative angle (a zero angle is parallel to the optical axis), to the first convex mirror $M_1$. The convex mirror $M_1$ reflects the beam upward to a large concave mirror $M_2$. The position of the second mirror $M_2$ has to be above the beam between the object (mask MA) and mirror $M_1$. The beam then goes under mirror $M_1$ to the stop surface mirror $M_3$. From the stop surface the beam is reflected to concave mirror $M_4$. Mirror $M_4$ takes care of a telecentric illumination of the image (surface 5). The first order curvatures and thicknesses of this system, in arbitrary units, are given in Table 3 below.
A class 6(-) system, shown in Figure 9, consists of two mirror pairs, in a symmetrical design. From the object (mask MA, surface 0) all the rays go, with a negative angle (a zero angle is parallel to the optical axis), to the first convex mirror $M_1$. The object is illuminated as telecentric as possible, this being a requirement for lithography. The convex mirror $M_1$ reflects the beam upward to a large concave mirror $M_2$. The position of this mirror has to be above the beam between the object and mirror $M_1$. So far this design resembles the class 2(-) design (shown in Figure 8). The beam then goes over mirror $M_1$ to the stop surface on mirror $M_3$, limited by the top of mirror $M_1$. From the stop surface $M_3$ the beam is reflected to concave mirror $M_4$. Mirror $M_4$ takes care of a telecentric illumination of the image (surface 5). The ring field of this system is defined on the image side, between -22.8 and -23.8, resulting in a Strehl ratio of at least 0.972 with a numerical aperture of 0.15. The first order curvatures and thicknesses of this system, in arbitrary units, are given in Table 4 below.
A class 9(-) system with a stop on the second surface is shown in Figure 10. The ring field of this system is defined on the object side, between 114 and 118 arbitrary units, with a numerical aperture of 0.2 (0.05 on the object side). The first order curvatures and thicknesses of this system, in arbitrary units, are given in Table 5 below.
Figure 11 shows a system in class 10(-). The ring field of this system is defined on the object side, between 114 and 118 arbitrary units, with a numerical aperture of 0.2 (0.05 on the object side). The first order curvatures and thicknesses of this system, in arbitrary units, are given in Table 6 below.

Preferred six-mirror systems

All the six-mirror systems found to be feasible have, as they have a positive magnification, an intermediate image.
Figure 12 shows a six-mirror system in class 9(+) in which the stop can be positioned on mirror 2, 3, 4 and 5. The system has the intermediate image located between mirror 2 and five. The ring field of this system is defined on the object side, between 114 and 118 arbitrary units, with a numerical aperture of 0.24 (0.06 on the object side). The first order curvatures and thicknesses of this system, in arbitrary units, are given in Table 7 below.
A class 37(+) six-mirror system can have the stop positioned on mirror 2, 3, 4 or 5 and has the intermediate image located between mirror 2 and five. The ring field of such a system is defined on the image side, between 27 and 30 arbitrary units, with a numerical aperture of 0.24.
The system shown in Figure 13 has the stop on surface 2. This system consists of a mirror pair near the object and four-mirrors grouped near the image. From the object (mask MA, surface 0) all the rays go, with a negative angle, to the first concave mirror $M_1$. The concave mirror $M_1$ reflects the beam downward to mirror $M_2$ which is almost flat. The top of mirror $M_2$ is restricted to be below the beam between the object and mirror $M_1$. The beam between mirror $M_2$ and $M_3$ limits the bottom of the small mirror $M_4$, whilst the beam between mirror $M_4$ and $M_5$ limits the top of mirror $M_4$. Finally, the beam between the last mirror $M_6$ and the image limits the top of mirror $M_5$. The first order curvatures and thicknesses of this system, in arbitrary units, are given in Table 8 below.
For comparison, Figure 14 shows a class 37(+) six-mirror system with the stop on surface 5. The ring field of this system is defined on the image side, between 27 and 30 arbitrary units, with a numerical aperture of 0.24. The first order curvatures and thicknesses of this system, in arbitrary units, are given in Table 9 below.

Preferred eight-mirror system

An eight-mirror system in class 165(+) with stop on surface 3 is shown in Figure 15. The ring field of this system is defined on the object side, between 116 and 124 arbitrary units, with a numerical aperture of 0.24 (0.06 on the object side). The first order curvatures and thicknesses of this system, in arbitrary units, are given in Table 10 below.

An eight mirror system in class 169(+) is shown in Figure 16, the curvatures and thicknesses of its elements are shown in Table 11. This system has a ring field in the object side between 114 and 118 arbitrary units, a numerical aperture of 0.4, distortion <2.9 nm and an rms wavefront error <0.3λ.

An eight mirror system in class 181 (+) is shown in Figure 17, the curvatures and thicknesses of its elements are shown in Table 12. Again, the ring field on the object side is between 114 and 118 units and the numerical aperture is 0.4. However, the distortion is <1.9 nm and the rms wavefront error <0.5λ.

An eight mirror system in class 150(-) is shown in Figure 18, the curvatures and thicknesses of its elements are shown in Table 13. This system provides a distortion <2.6 nm and an rms wavefront error <0.19λ.

An eight mirror system in class 182(-) is shown in Figure 19, the curvatures and thicknesses of its elements are shown in Table 14. This system likewise has a ring field on the object side between 114 and 118 arbitrary units, a numerical aperture of 0.4, an rms wavefront error of <1λ and a distortion <2.18 nm.

Whilst we have described above specific embodiments of the invention it will be appreciated that the invention may be practiced otherwise than described. The description is not intended to limit the invention.

Table 1

| | Curvature | | Thickness |
|---|---|---|---|
| | | $d_0$ | 834.233264 |
| $c_1$ | -0.00014266 | $d_1$ | -599.763693 |
| $c_2$ | 0.00088498 | $d_2$ | 684.179623 |
| $c_3$ | -0.00998244 | $d_3$ | -83.415929 |
| $c_4$ | 0.01918223 | $d_4$ | 61.797248 |
| | | $d_5$ | 16.018048 |

Table 2

| | Curvature | | Thickness |
|---|---|---|---|
| | | $d_0$ | 616.993869 |
| $c_1$ | -0.00243396 | $d_1$ | -633.892913 |
| $c_2$ | 0.00190431 | $d_2$ | 636.600251 |
| $c_3$ | 0.00025705 | $d_3$ | -69.291720 |
| $c_4$ | 0.00724502 | $d_4$ | 64.788741 |
| | | $d_5$ | 4.467388 |

Table 3

| | Curvature | | Thickness |
|---|---|---|---|
| | | $d_0$ | 359.695357 |
| $c_1$ | 0.00152836 | $d_1$ | -274.181525 |
| $c_2$ | 0.00259323 | $d_2$ | 261.925120 |
| $c_3$ | 0.01867917 | $d_3$ | -26.735917 |
| $c_4$ | 0.01765947 | $d_4$ | 48.776080 |
| | | $d_5$ | -0.416277 |

Table 4

| | Curvature | | Thickness |
|---|---|---|---|
| | | $d_0$ | 767.692000 |
| $c_1$ | 0.00300902 | $d_1$ | -642.472629 |
| $c_2$ | 0.00095506 | $d_2$ | 1445.239615 |
| $c_3$ | 0.00407728 | $d_3$ | -78.092188 |
| $c_4$ | 0.00607760 | $d_4$ | 94.620253 |
| | | $d_5$ | -1.961967 |

Table 5

| | Curvature | | Thickness |
|---|---|---|---|
| | | $d_0$ | 449.444384 |
| $c_1$ | -0.00042724 | $d_1$ | -396.786263 |
| $c_2$ | -0.00168067 | $d_2$ | 403.457960 |
| $c_3$ | -0.00659922 | $d_3$ | -67.000191 |
| $c_4$ | -0.01721598 | $d_4$ | 54.629940 |
| | | $d_5$ | 4.695013 |

Table 6

| | Curvature | | Thickness |
|---|---|---|---|
| | | $d_0$ | 444.844414 |
| $c_1$ | -0.00256672 | $d_1$ | -83.893940 |
| $c_2$ | -0.00023614 | $d_2$ | 80.638988 |
| $c_3$ | 0.01329749 | $d_3$ | -42.956528 |
| $c_4$ | 0.01099286 | $d_4$ | 93.755560 |
| | | $d_5$ | -0.762586 |

Table 7

| | Curvature | | Thickness |
|---|---|---|---|
| | | $d_0$ | 131.380868 |
| $c_1$ | 0.00289128 | $d_1$ | -113.331683 |
| $c_2$ | 0.00499283 | $d_2$ | 146.579813 |
| $c_3$ | 0.00863830 | $d_3$ | -93.218415 |
| $c_4$ | 0.01007555 | $d_4$ | 88.970994 |
| $c_5$ | 0.01220780 | $d_5$ | -93.941281 |
| $c_6$ | 0.00873868 | $d_6$ | 116.487572 |
| | | $d_7$ | -0.127679 |

Table 8

| | Curvature | | Thickness |
|---|---|---|---|
| | | $d_0$ | 828.570000 |
| $c_1$ | -0.00111627 | $d_1$ | -304.777604 |
| $c_2$ | -0.00007435 | $d_2$ | 680.858425 |
| $c_3$ | -0.00238747 | $d_3$ | -160.275601 |
| $c_4$ | -0.00019501 | $d_4$ | 124.017066 |
| $c_5$ | 0.00719636 | $d_5$ | -145.964808 |
| $c_6$ | 0.00467166 | $d_6$ | 231.541247 |
| | | $d_7$ | 0.075648 |

Table 9

| | Curvature | | Thickness |
|---|---|---|---|
| | | $d_0$ | 405.798032 |
| $c_1$ | -0.00475154 | $d_1$ | -64.654405 |
| $c_2$ | -0.00852932 | $d_2$ | 487.659410 |
| $c_3$ | -0.00286217 | $d_3$ | -202.163489 |
| $c_4$ | -0.00307574 | $d_4$ | 230.915333 |
| $c_5$ | 0.00000503 | $d_5$ | -116.766023 |
| $c_6$ | 0.00422514 | $d_6$ | 189.881646 |
| | | $d_7$ | 0.000000 |

Table 10

| | Curvature | | Thickness |
|---|---|---|---|
| | | $d_0$ | 322.380000 |
| $c_1$ | -0.00178490 | $d_1$ | -108.516829 |
| $c_2$ | -0.00245113 | $d_2$ | 174.110025 |
| $c_3$ | -0.00202694 | $d_3$ | -168.774787 |
| $c_4$ | -0.00124407 | $d_4$ | 983.268141 |
| $c_5$ | -0.00183868 | $d_5$ | -213.604816 |
| $c_6$ | -0.00200081 | $d_6$ | 274.820705 |
| $c_7$ | 0.00126629 | $d_7$ | -197.754689 |
| $c_8$ | 0.00476144 | $d_8$ | 160.164412 |
| | | $d_9$ | 0.000000 |

Table 11

| | Curvature | | Thickness |
|---|---|---|---|
| | | $d_0$ | 420.601299 |

(continued)

| | Curvature | | Thickness |
|---|---|---|---|
| $c_1$ | -0.00323603 | $d_1$ | -125.470789 |
| $c_2$ | -0.00902233 | $d_2$ | 110.112590 |
| $c_3$ | -0.00206939 | $d_3$ | -160.044449 |
| $c_4$ | 0.00036641 | $d_4$ | 258.697858 |
| $c_5$ | 0.00126054 | $d_5$ | -279.043974 |
| $c_6$ | 0.00146300 | $d_6$ | 905.704090 |
| $c_7$ | 0.00275699 | $d_7$ | -111.254872 |
| $c_8$ | 0.00673385 | $d_8$ | 112.775777 |
| | | $d_9$ | 0 |

Table 12

| | Curvature | | Thickness |
|---|---|---|---|
| | | $d_0$ | 455.886404 |
| $c_1$ | -0.00355263 | $d_1$ | -116.531978 |
| $c_2$ | -0.00563559 | $d_2$ | 515.664329 |
| $c_3$ | -0.00151867 | $d_3$ | -282.841809 |
| $c_4$ | 0.00151480 | $d_4$ | 89.911348 |
| $c_5$ | 0.00127162 | $d_5$ | -49.006196 |
| $c_6$ | -0.00070814 | $d_6$ | 152.535737 |
| $c_7$ | 0.00667355 | $d_7$ | -82.044394 |
| $c_8$ | 0.00867329 | $d_8$ | 98.259942 |
| | | $d_9$ | 0.267746 |

Table 13

| | Curvature | | Thickness |
|---|---|---|---|
| | | $d_0$ | 713.868812 |
| $c_1$ | -0.00187689 | $d_1$ | -225.978195 |
| $c_2$ | -0.00045910 | $d_2$ | 871.620787 |
| $c_3$ | -0.00138063 | $d_3$ | -601.119900 |
| $c_4$ | -0.00002434 | $d_4$ | 269.267756 |
| $c_5$ | 0.00166695 | $d_5$ | -342.201234 |
| $c_6$ | 0.00162141 | $d_6$ | 807.574290 |
| $c_7$ | 0.00773514 | $d_7$ | -167.796714 |
| $c_8$ | 0.00506893 | $d_8$ | 169.913678 |
| | | $d_9$ | 0 |

Table 14

| | Curvature | | Thickness |
|---|---|---|---|
| | | $d_0$ | 84.702306 |
| $c_1$ | -0.00487728 | $d_1$ | -49.028673 |
| $c_2$ | -0.01142777 | $d_2$ | 677.956498 |
| $c_3$ | -0.00154677 | $d_3$ | -710.120744 |
| $c_4$ | 0.00369184 | $d_4$ | 305.647599 |
| $c_5$ | 0.00218954 | $d_5$ | -323.556990 |
| $c_6$ | 0.00163258 | $d_6$ | 878.491460 |
| $c_7$ | 0.00460099 | $d_7$ | -136.990287 |
| $c_8$ | 0.00616448 | $d_8$ | 137.341290 |
| | | $d_9$ | 0 |

## Claims

**1.** A lithographic projection apparatus comprising:

a radiation system for providing a projection beam of radiation;
a support structure for supporting patterning means, the patterning means serving to pattern the projection beam according to a desired pattern;
a substrate table for holding a substrate;
a projection system for projecting the patterned beam onto a target portion of the substrate,
**characterized in that**:
said projection system has precisely six imaging mirrors in the optical path of the projection beam and has an incidence angle classification, C, of 5(+), 6(-), 9(+), 13(+), 18(-), 21(+), 22(-), 25(+), 29(+), 34(-), 38(-),or 54(-), where:

$$C = \sum_{i=1}^{6} a_i . 2^{(6-i)} \quad \left(\frac{M}{|M|}\right)$$

$a_i$ = 1 if the angle of incidence of the chief ray at mirror *i* is negative,
$a_i$ = 0 if the angle of incidence of the chief ray at mirror *i* is positive,
M is the magnification of the projection system, and
the index *i* numbers the mirrors from object to image.

**2.** Apparatus according to claim 1, wherein said projection system has a stop located on the second, third, fourth or fifth mirror.

**3.** Apparatus according to claim 1 or 2, wherein said projection system has an intermediate image between the second and fifth mirror.

**4.** Apparatus according to any one of the preceding claims wherein said projection system has the smallest deviation from telecentricity whilst still enabling obscuration-free illumination of the mask such that, for each point on the object, in the pencil of rays leaving the object, the ray forming the smallest angle with the optical axis forms an angle not larger than 10° to the optical axis.

**5.** Apparatus according to any one of the preceding claims wherein said projection is substantially telecentric on the image side such that for each point on the object, the ray passing through the center of the aperture stop forms in the image space an angle with the optical axis not larger than 1°.

6. Apparatus according to any one of the preceding claims wherein each mirror in said projection system is substantially rotationally symmetric about an optical axis.

7. Apparatus according to any one of the preceding claims wherein said projection system has a magnification whose absolute value is in the range of from 1/3 to 1/10 and preferably substantially equal to 1/4 or 1/5.

8. Apparatus according to any one of the preceding claims wherein said projection beam comprises extreme ultraviolet radiation, e.g. having a wavelength in the range of from 8 to 20nm, preferably 9 to 16nm.

9. An apparatus according to any one of the preceding claims, wherein the support structure comprises a mask table for holding a mask.

10. An apparatus according to any one of the preceding claims, wherein the radiation system comprises a radiation source.

11. A device manufacturing method comprising the steps of:

providing a substrate that is at least partially covered by a layer of radiation-sensitive material;
providing a projection beam of radiation using a radiation system;
using patterning means to endow the projection beam with a pattern in its cross-section;
projecting the patterned beam of radiation onto a target portion of the layer of radiation-sensitive material;
**characterized in that**:

in the step of imaging, a projection system as defined in any one of the preceding claims is used.

Fig. 1

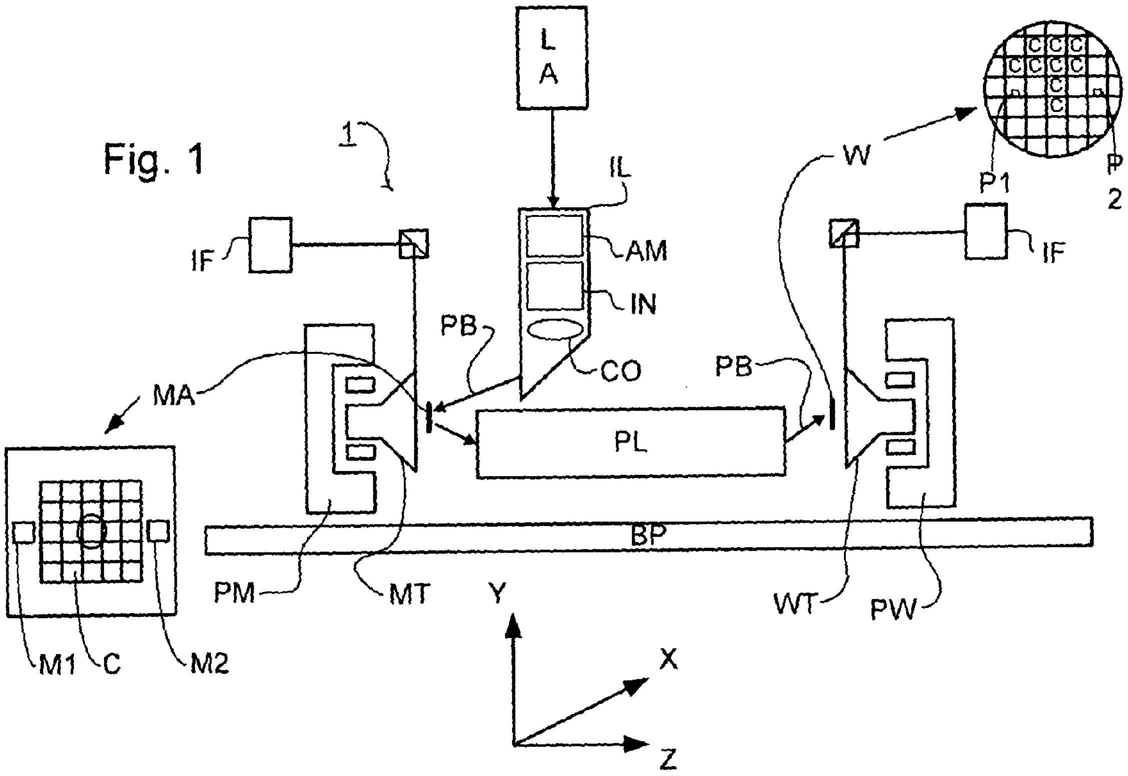
1
L
A
IL
AM
IN
CO
IF
IF
W
P1
P
2
C
PB
PB
MA
PL
BP
PM
MT
Y
X
Z
WT
PW
M1
C
M2

Fig. 2

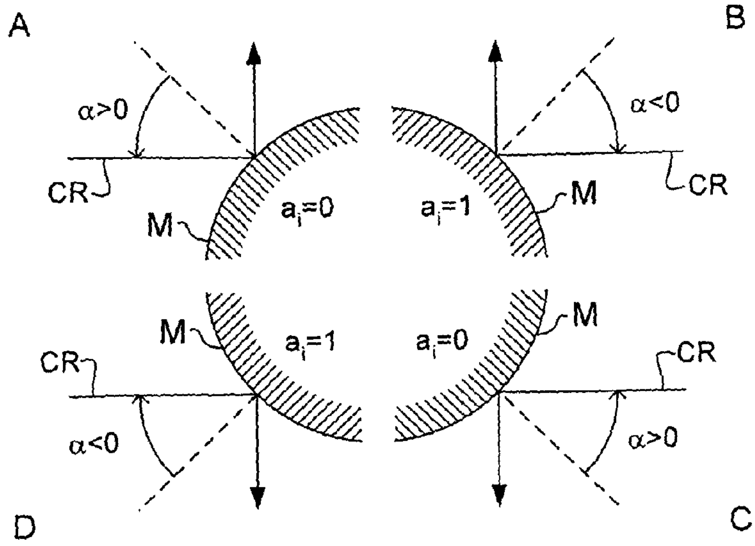
A
B
α>0
α<0
CR
CR
M
M
$a_i$=0
$a_i$=1
M
M
$a_i$=1
$a_i$=0
CR
CR
α<0
α>0
D
C

Fig. 3

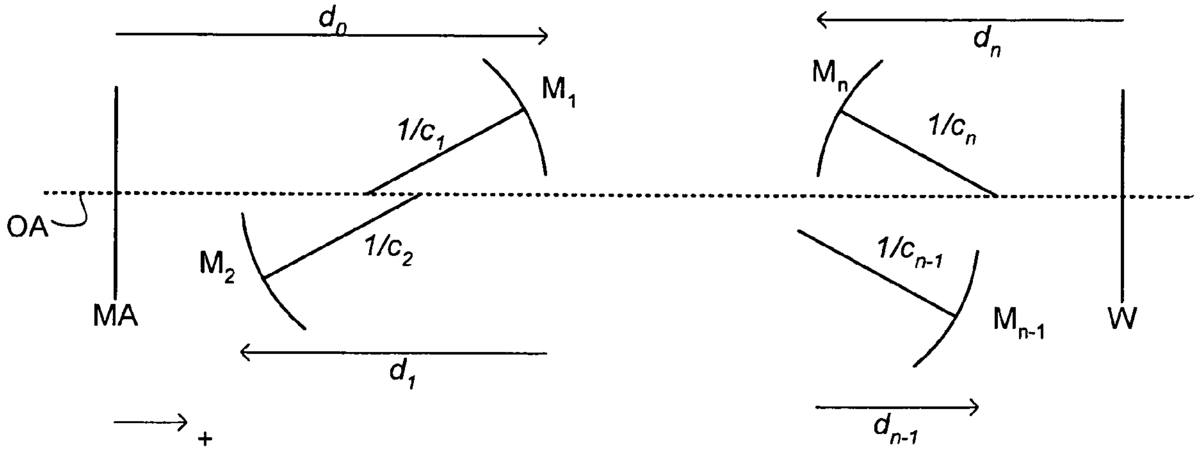


Fig. 4

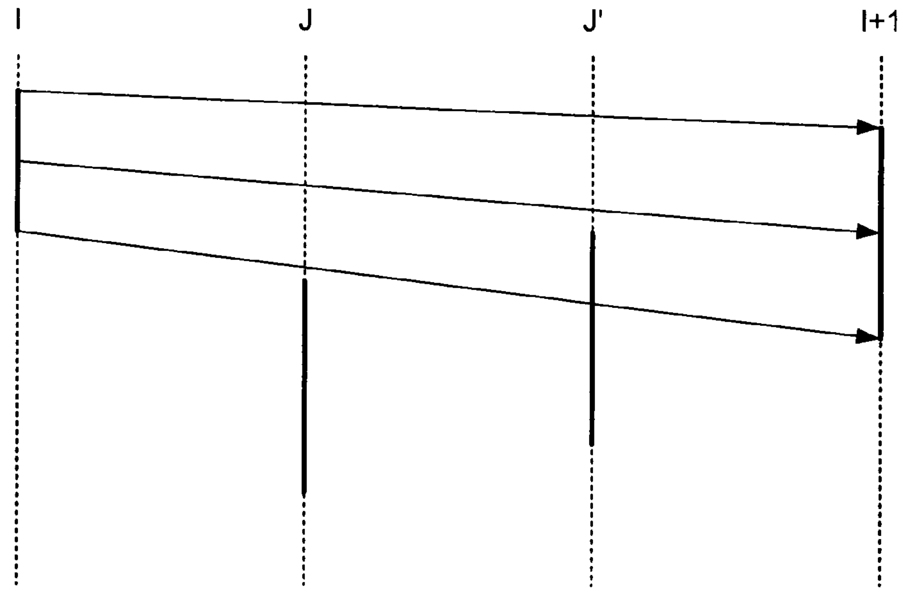

Fig. 5

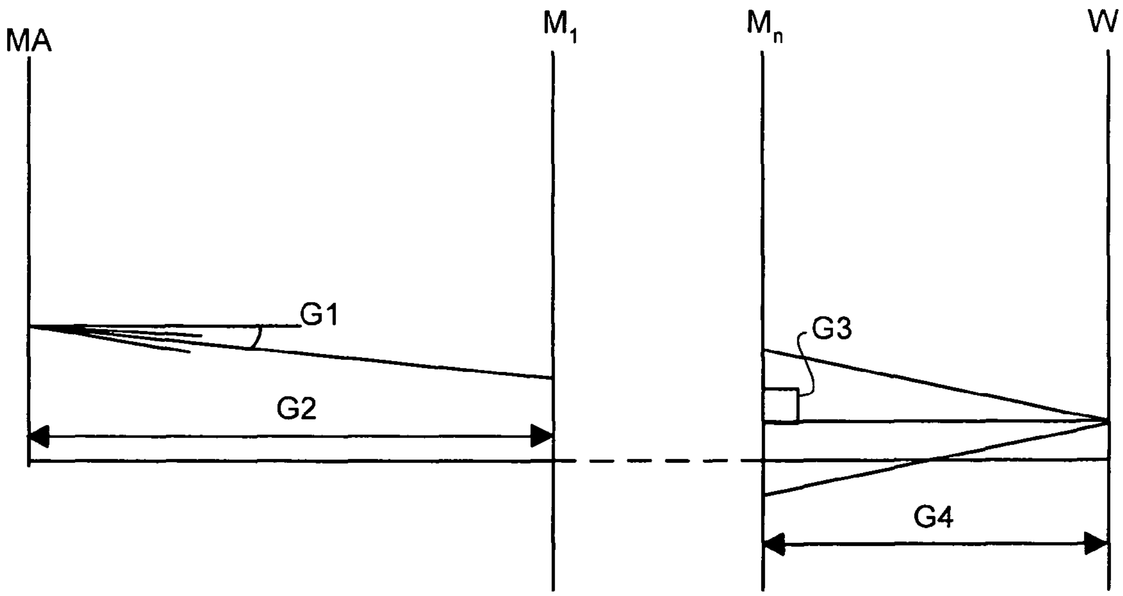


Fig. 6

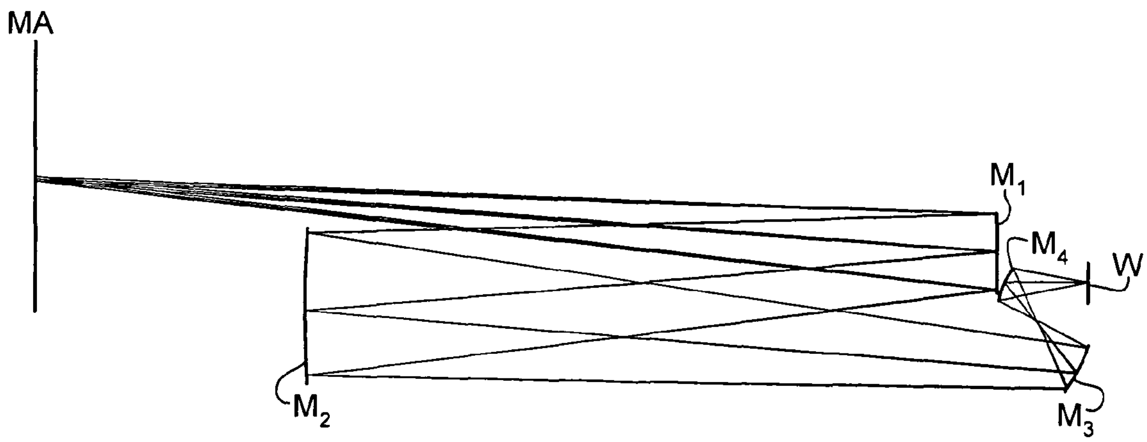

Fig. 7

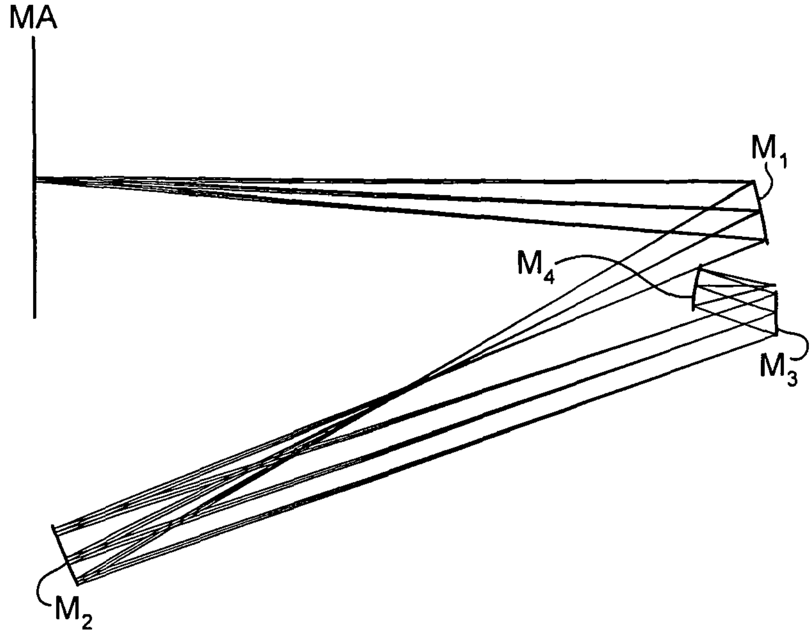


Fig. 8

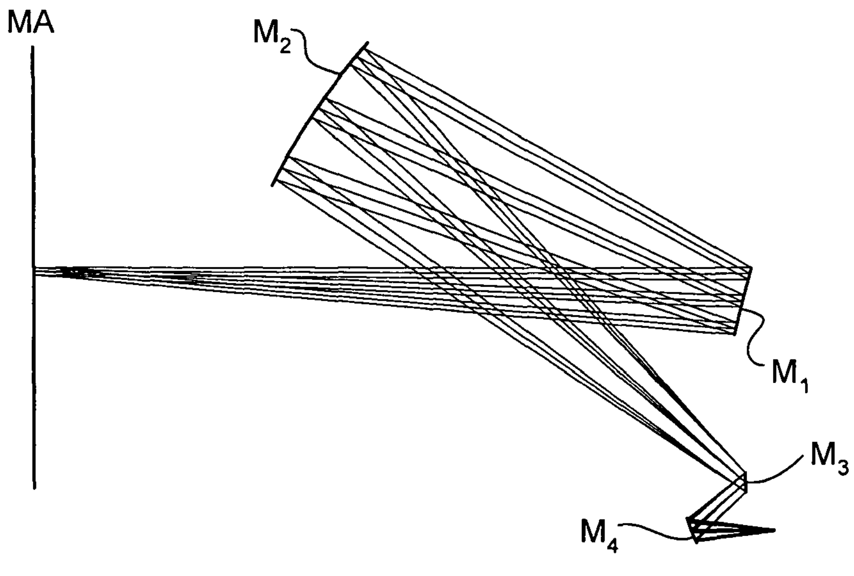

Fig. 9

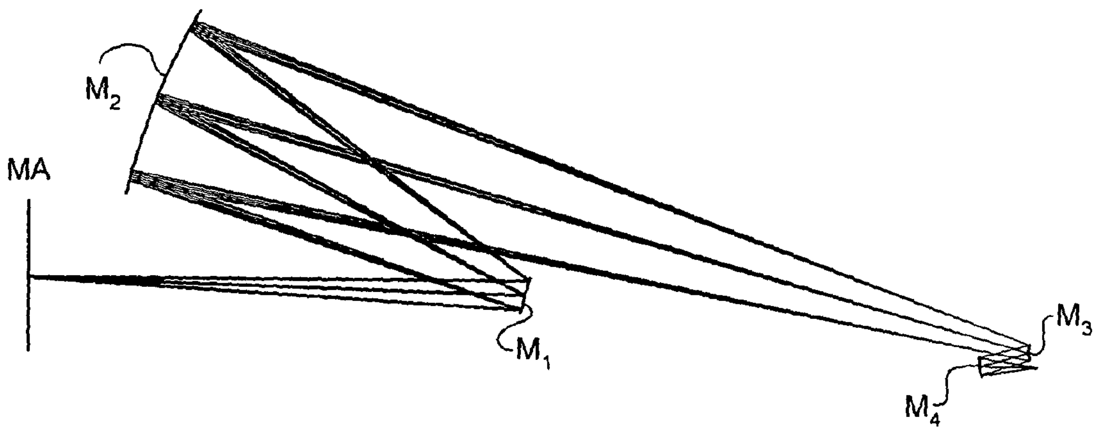


Fig. 10

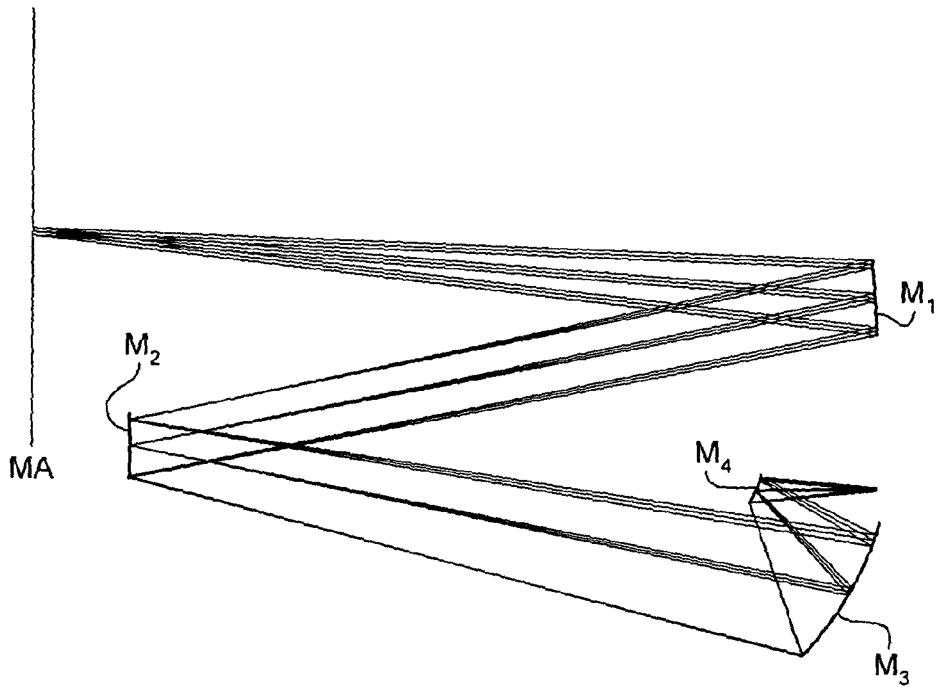

Fig. 11

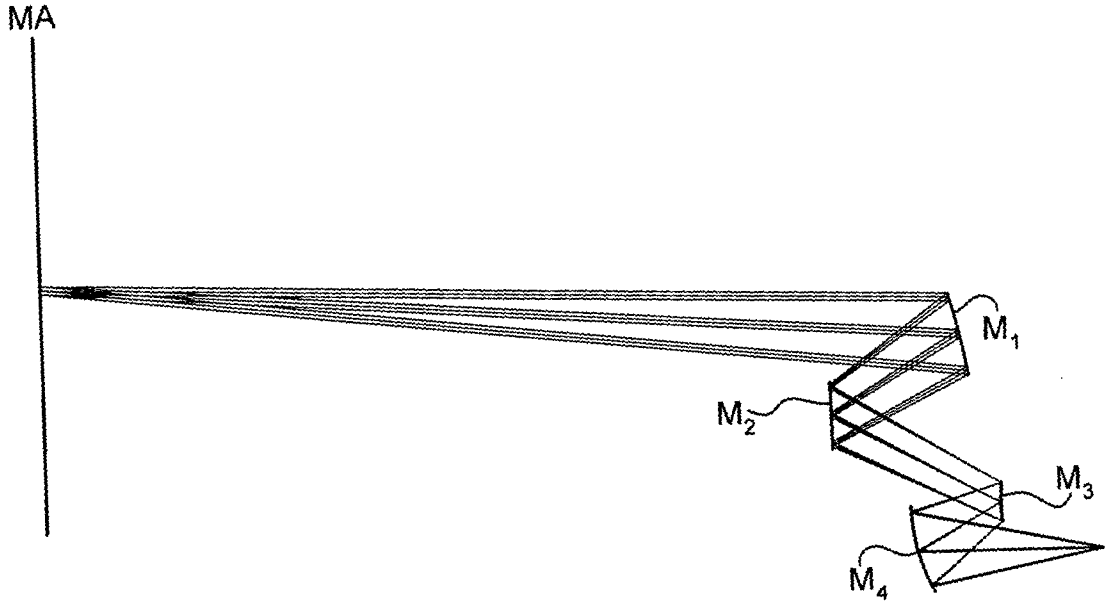


Fig. 12

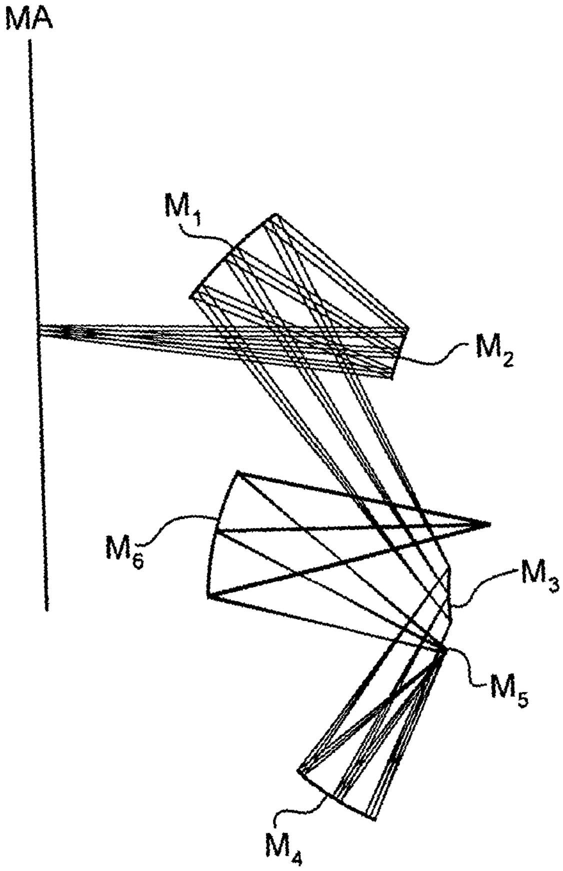

Fig. 13

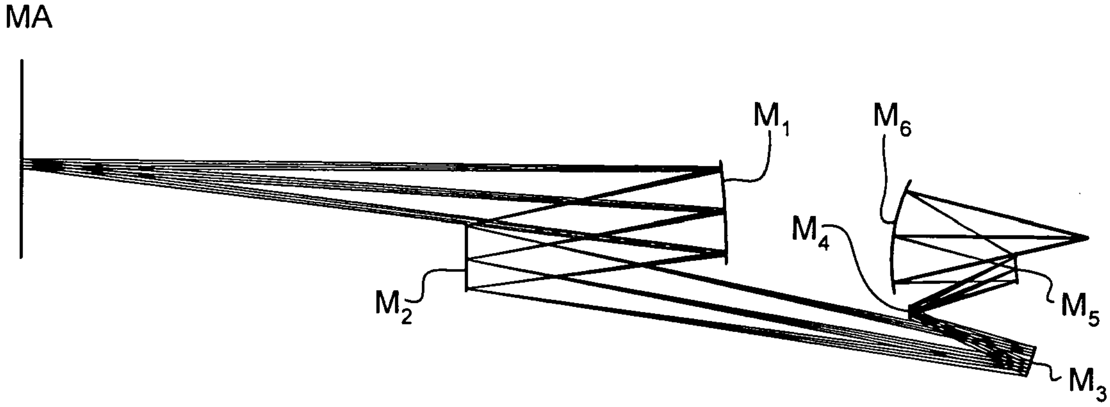


Fig. 14

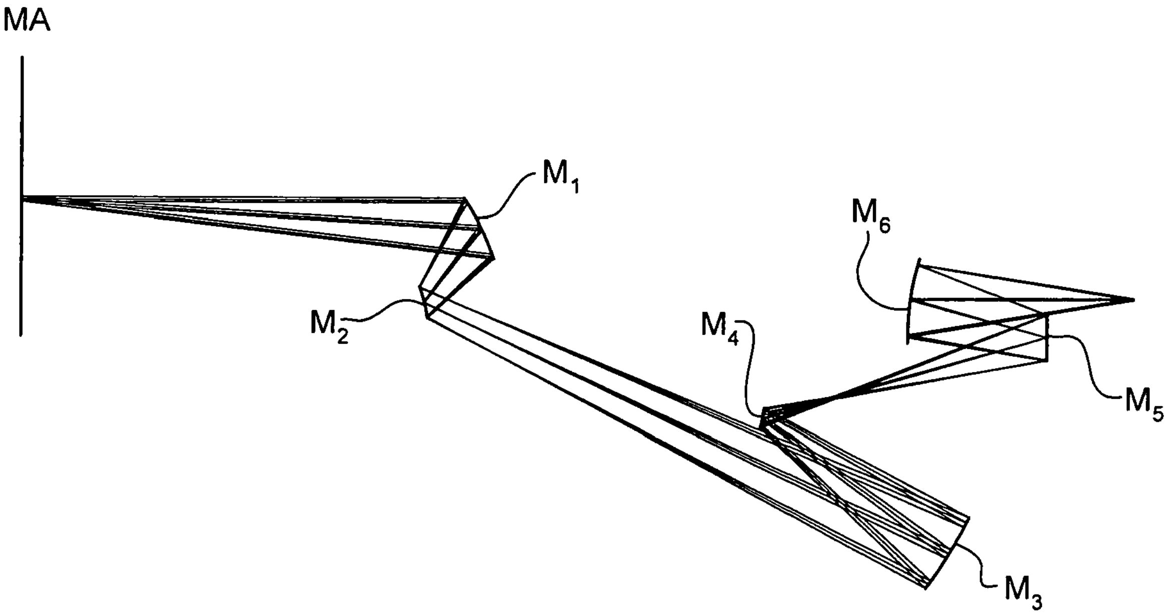

Fig. 15

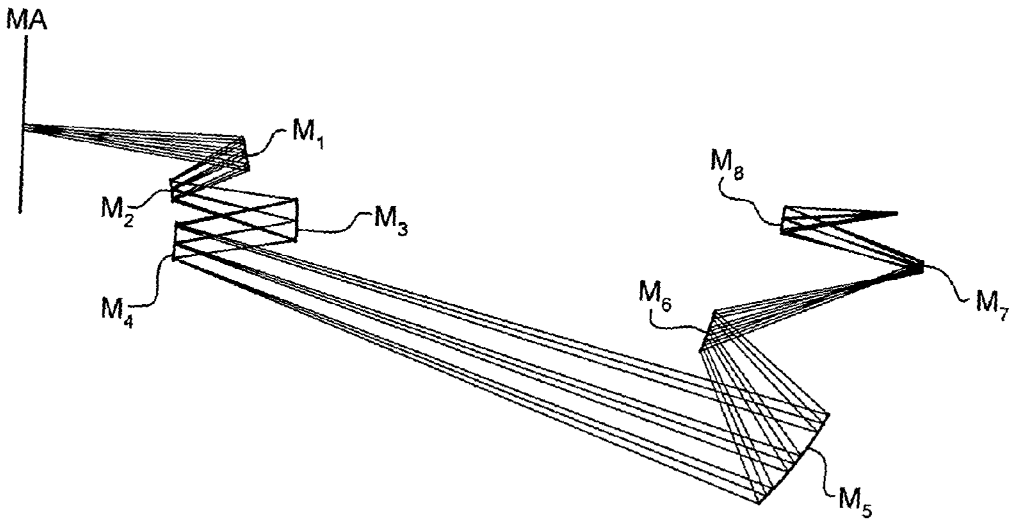


Fig. 16

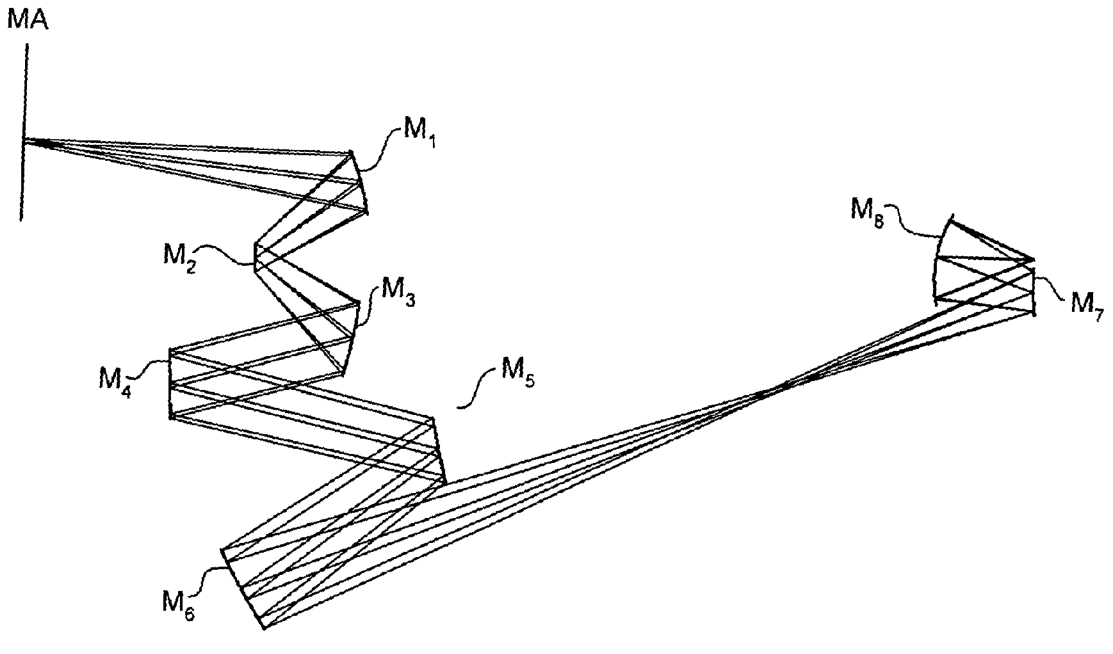

Fig. 17

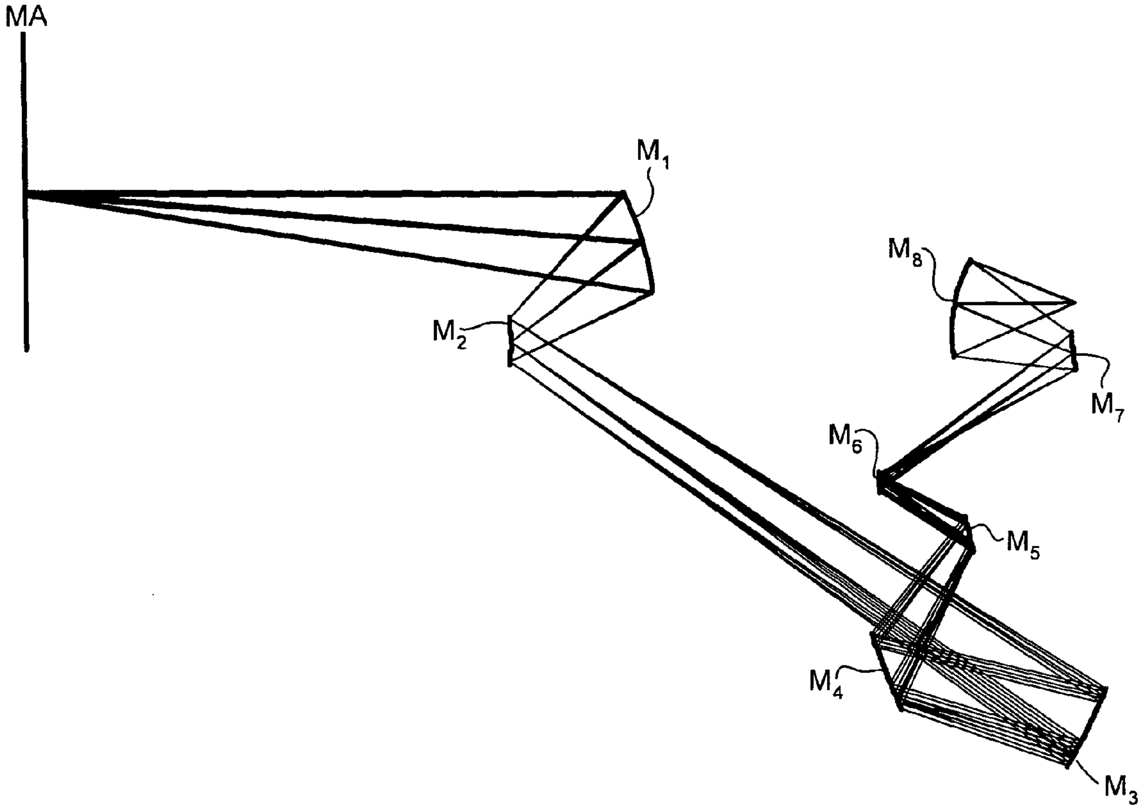


Fig. 18

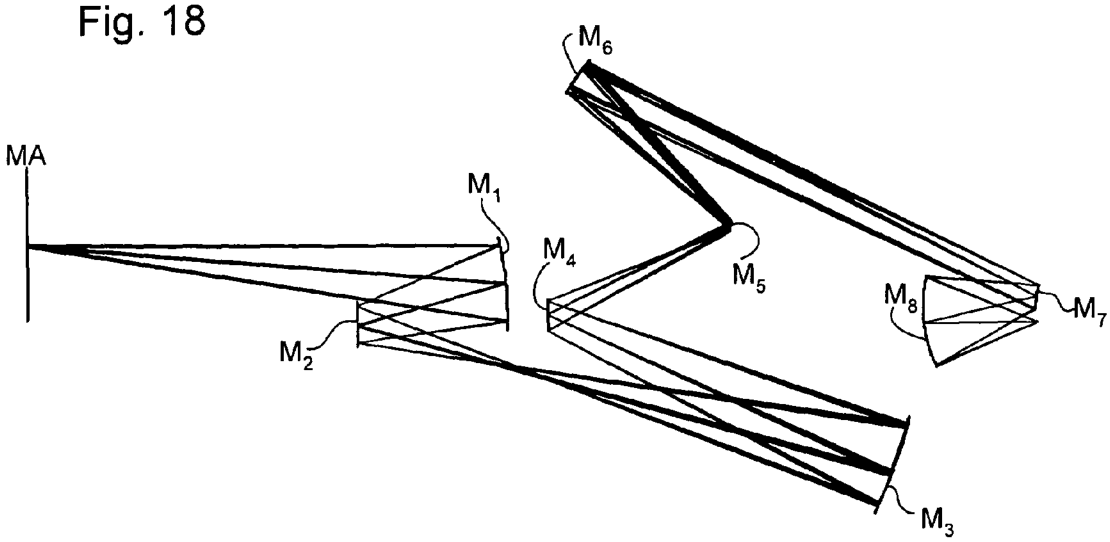

Fig. 19

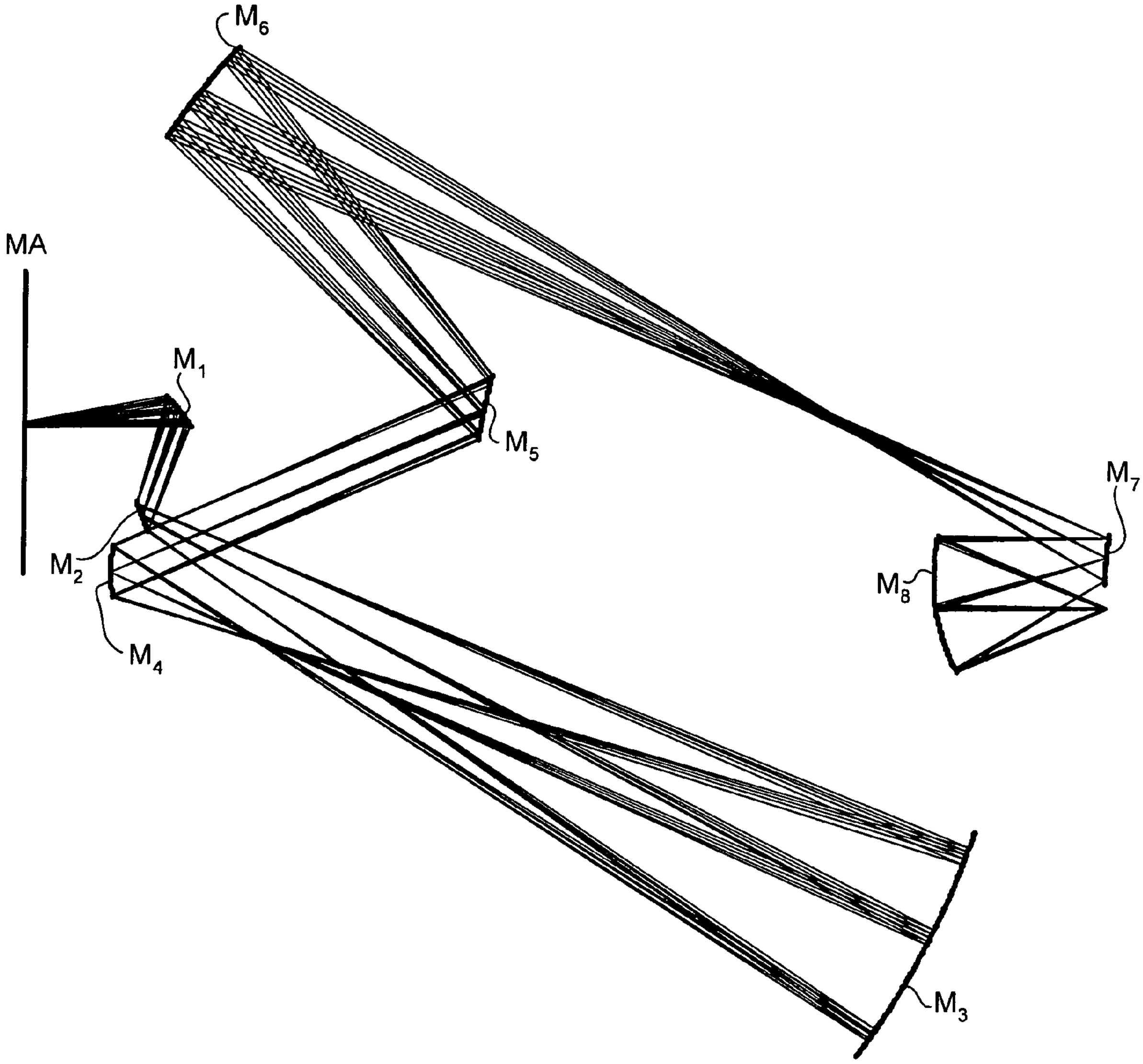

European Patent Office

# EUROPEAN SEARCH REPORT

Application Number
EP 06 00 4927

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2000 100694 A (NIPPON KOGAKU KK) 7 April 2000 (2000-04-07) * figures 1,2 * & US 6 172 825 B1 (TAKAHASHI TOMOWAKI) 9 January 2001 (2001-01-09) * figures 1,2 * * column 6, line 25 - column 8, line 26 * ----- | 1-11 | INV. G03F7/20 G02B17/06 |
| A | US 5 686 728 A (SHAFER DAVID ROSS) 11 November 1997 (1997-11-11) * figure 2 * ----- | 1-11 | |
| A,D | EP 0 779 528 A (SVG LITHOGRAPHY SYSTEMS INC) 18 June 1997 (1997-06-18) * page 3 * ----- | 1-11 | |
| A,D | LERNER S A ET AL: "DESIGN APPROACH AND COMPARISON OF PROJECTION CAMERAS FOR EUV LITHOGRAPHY" OPTICAL ENGINEERING, SOC. OF PHOTO-OPTICAL INSTRUMENTATION ENGINEERS. BELLINGHAM, US, vol. 39, no. 3, March 2000 (2000-03), pages 792-802, XP001051258 ISSN: 0091-3286 * figure 10 * ----- | 1-11 | TECHNICAL FIELDS SEARCHED (IPC): G02B G03F |

~~The present search report has been drawn up for all claims~~

| Place of search | Date of completion of the search | Examiner |
|---|---|---|
| The Hague | 29 May 2006 | Quertemont, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

8

EPO FORM 1503 03.82 (P04C01)

European Patent Office

Application Number

EP 06 00 4927

## CLAIMS INCURRING FEES

The present European patent application comprised at the time of filing more than ten claims.

- [ ] Only part of the claims have been paid within the prescribed time limit. The present European search report has been drawn up for the first ten claims and for those claims for which claims fees have been paid, namely claim(s):

- [X] No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

- [X] All further search fees have been paid within the fixed time limit. The present European search report has been drawn up for all claims.

- [ ] As all searchable claims could be searched without effort justifying an additional fee, the Search Division did not invite payment of any additional fee.

- [ ] Only part of the further search fees have been paid within the fixed time limit. The present European search report has been drawn up for those parts of the European patent application which relate to the inventions in respect of which search fees have been paid, namely claims:

- [ ] None of the further search fees have been paid within the fixed time limit. The present European search report has been drawn up for those parts of the European patent application which relate to the invention first mentioned in the claims, namely claims:

European Patent Office

# LACK OF UNITY OF INVENTION SHEET B

Application Number

EP 06 00 4927

The Search Division considers that the present European patent application does not comply with the requirements of unity of invention and relates to several inventions or groups of inventions, namely:

1. claims: 1-3,8-15

   A lithographic projection apparatus comprising a projection system having precisely four imaging mirrors and satisfying stated incident angle classification conditions

   ---

2. claims: 4-6,8-15

   A lithographic projection apparatus comprising a projection system having precisely six imaging mirrors and satisfying stated incident angle classification conditions

   ---

3. claims: 7-15

   A lithographic projection apparatus comprising a projection system having precisely eight imaging mirrors and satisfying stated incident angle classification conditions

   ---